(19) **Europäisches Patentamt / European Patent Office / Office européen des brevets**

(11) **EP 1 852 763 A1**

(12) **EUROPEAN PATENT APPLICATION**
published in accordance with Art. 158(3) EPC

(43) Date of publication:
07.11.2007 Bulletin 2007/45

(51) Int Cl.:
*G05D 3/12* (2006.01)   *G03F 9/00* (2006.01)
*G12B 5/00* (2006.01)   *H01L 21/027* (2006.01)
*H01L 21/68* (2006.01)

(21) Application number: 06713884.2

(22) Date of filing: 16.02.2006

(86) International application number:
PCT/JP2006/302743

(87) International publication number:
WO 2006/088098 (24.08.2006 Gazette 2006/34)

(84) Designated Contracting States:
NL

(30) Priority: 18.02.2005 JP 2005041562

(71) Applicant: Yokogawa Electric Corporation
Tokyo 180-8750 (JP)

(72) Inventors:
• NIKAIDO, Mitsuhiro
2-chome, Musashino-shi, Tokyo, 1808750 (JP)

• KOIZUMI, Yutaka
2-chome, Musashino-shi, Tokyo, 1808750 (JP)
• KAIHO, Fumio
2-chome, Musashino-shi, Tokyo, 1808750 (JP)

(74) Representative: Grünecker, Kinkeldey,
Stockmair & Schwanhäusser
Anwaltssozietät
Maximilianstrasse 58
80538 München (DE)

(54) **XY STAGE**

(57)    An XY stage for controlling a position of a slider part on a lattice platen in two-dimensional directions has a plurality of the slider parts whose positions are controlled independently. The plurality of the slider parts each has: aposition controlling part for controlling a position of the slider part in an X axis direction and a Y axis direction; and a yawing correcting part for correcting a yawing of the slider part around a Z axis.

Fig. 4

**Description**

**FIELD OF THE INVENTION**

The present invention relates to an XY stage for controlling a position of a slider part above a lattice platen in two-dimensional directions. An XY stage is widely utilized in semiconductor fabrication, a semiconductor inspecting apparatus, an integrating apparatus, a printing apparatus or the like.

**BACKGROUND ART**

An XY stage having a plurality of slider parts is described in JP-A-2002-116239.
JP-A-2002-116239 is cited as a related art.
JP-A-2000-65970 describes a structure of an XY stage having a lattice platen and a slider part a position of which is controlled by being slid in an X axis direction and a Y axis direction of an upper face thereof and a technology of restraining yawing of a slider part.
JP-A-2000-65970 is cited as a related art.

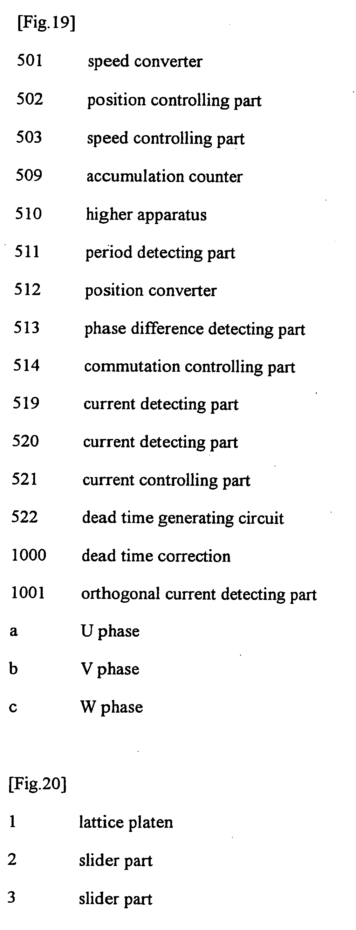

Fig. 20 is a plane view showing a constitution of an XY stage having a plurality of slider parts disclosed in JP-A-2002-116239. A technology disclosed in the plane view is a device inspecting apparatus promoting a tact.
Numeral 1 designates a lattice platen. Numeral 2 designates a slider part at (A) position, numeral 3 designates a slider part at (B) position, a position of which is controlled in two-dimensional directions (X, Y) above an upper face of a lattice platen 1. Numeral 4 designates a device constituting an object of inspection mounted on the slider part 2, numeral 5 designates a device constituting an object of inspection mounted on the slider part 3. Numeral 6 designates a control part, numerals 7 and 8 designate a camera and an inspecting part operated by the control part.
An image of the position of the device 4 constituting the object of inspection mounted on the slider part 2 at (A) position is measured by the camera 7, and an alignment of calculating a deviation in a state of arranging the device is carried out. At the same time, a probe 9 of the inspecting part 8 is brought into contact with the device 5 mounted on the slider part 3 at (B) position to carry out an inspection.
When the inspection has been finished, the slider part 2 mounted with the device 4 after the alignment at (A) position is carried to (B) position of carrying out inspection (arrow mark P1) and at the same time, the slider part 3 mounted with the device 5 after the inspection is carried to (A) position for carrying out the alignment (arrow mark P2).
According to the device 4 carried to (B) position, the device is positioned based on a deviation amount calculated by the alignment, thereafter, the inspection is carried out. The device 5 carried to (A) position is interchanged by a new device and the alignment is carried out.

In this way, there is repeated a step of alternately switching the slider part 2 and the slider part 3 to (A) position of carrying out the alignment and (B) position for carrying out the inspection and carrying out the alignment of a successive device constituting the object of inspection at other slider part during a time period of inspecting the device at one slider part. The control part 6 controls such that a path of moving the slider part 2 and a path of moving the slider part 3 are constituted by separate paths which are not intersected by each other.

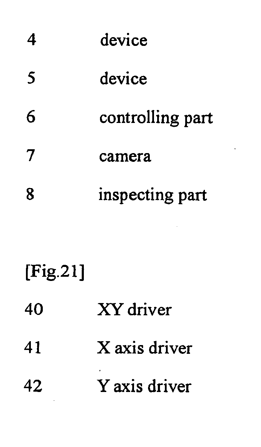

Fig. 21 is a function block diagram for explaining a two-dimensional position control system of the slider part 2. The lattice platen 1 arranged to be fixed horizontally is formed with teeth at constant pitches along X direction and Y direction. In the drawing, only a portion of the teeth is shown for simplification. The lattice platen is formed by cutting grooves to a flat face of a magnetic member in a lattice-like shape.
Numeral 2 designates the slider part controlled to be positioned by being slid in X direction and Y direction above an upper face of the lattice platen, and an upper portion thereof is mounted with a work and a device constituting an object of positioning. A float up part 21 is provided with a nozzle at a back face thereof opposed to the lattice platen 1 for floating up the slider 2 above the lattice platen 1 by injecting compressed air thereto.
Numeral 31 designates an X axis sensor arranged to be fixed to the upper portion of the slider part 2. Numeral 32 designates a Y axis sensor similarly arranged to be fixed to the upper portion of the slider part 2. Numeral 11 designates an X axis mirror having a predetermined height arranged to be fixed to one end portion of an X axis of the lattice platen 1 orthogonally to the X axis to be opposed to the X axis sensor 31. Numeral 12 designates a Y axis mirror having a predetermined height arranged to be fixed to one end portion of a Y axis of the lattice platen 1 orthogonally to the Y axis to be opposed to the Y axis sensor 32.
The Y axis sensor 31 and the Y axis sensor 32 are optical distance measuring apparatus for measuring positions of the slider part 2 in X direction and Y direction by irradiating a laser beam to the X axis mirror 11 and the Y axis mirror 12 and receiving reflected light and measuring a moving distance by utilizing interference. Notation PX designates a measured value of a distance in the X axis direction by the X axis sensor 31 and notation PY designates a measured value of the Y direction distance by the Y axis sensor 33. A principle of measuring a distance by an interferometer is disclosed in details in JP-A-2000-65970.
A block 40 is an XY servo driver comprising an X axis driver 41 and a Y axis driver 42. The X axis driver 41 calculates a deviation between the measured coordinate PX and a target position signal SX provided from a higher apparatus and outputs a control current MX to an X motor (not illustrated) realized by a face motor mounted on the slider 2. The Y axis driver 42 calculates a deviation between the measured coordinate PY and a target position signal SY provided from the higher apparatus and outputs a control current MY to a Y motor mounted on the slider 2. Also a principle of a two-dimensional position control by the X motor and the Y motor is disclosed in details in JP-A-2000-65970.

## DISCLOSURE OF THE INVENTION

## PROBLEMS TO BE RESOLVED BY THE INVENTION

According to a semiconductor fabricating apparatus using an XY stage having a plurality of slider parts, there are needed a fine movement control of a photomask and a fine position control of the slider mounted with a device at an exposure step and a highly accurate positioning accuracy is requested for the slider. In such a XY slider, the following problem is posed.
(1) In controlling the two-dimensional position of the slider part, a rotation (yawing) around a Z axis is brought about, which constitutes a factor of hampering promotion of a positioning accuracy.

(2) When the two-dimensional position of the slider part is controlled, a change in the Z axis direction of the slider part (a variation in a distance between the slider part and the lattice platen), that is, rolling or pitching is generated, which constitutes a factor of hampering promotion of the positioning accuracy.

(3) As a weak point of a face motor of a hybrid type, there poses a problem of superposing a ripple in controlling the position of the slider by a cogging thrust generated in synchronism with a commutation period of an alternating current control current supplied to the motor, which constitutes a factor of hampering promotion of the positioning accuracy.

(4) When a speed control loop is provided to a control loop for controlling the two-dimensional position of the slider part, a variation is brought about in a detected value of a speed when a loop gain is small to constitute a disturbance of a motor thrust force constituting a factor by a thrust by cogging, a thrust ripple or the like. When a gain is increased, in a case of a large signal delay in the loop or when a mechanical system resonance is present in the motor, the motor is resonated, and therefore, the gain is restricted, which constitutes a factor of hampering promotion of the positioning accuracy.

(5) By a dead zone by a dead time generating circuit provided when a control current to a face motor is supplied by way of a switching circuit, a current distortion or a response delay is provided when a current is small to produce a small amplitude to deteriorate a characteristic of controlling the motor. The deterioration constitutes a factor of hampering promotion of the positioning accuracy.

It is an object of the invention to realize an XY stage having a plurality of slider parts including a correcting part in correspondence with a factor of hampering promotion of a positioning accuracy caused by yawing, pitching and rolling, cogging, a loop gain in a speed control, a dead time generating circuit.

## MEANS OF SOLVING THE PROBLEMS

The invention provides an XY stage for controlling a position of a slider part on a lattice platen in two-dimensional directions, the XY stage comprising a plurality of the slider parts whose positions are controlled independently, and the plurality of the slider parts each comprises: a position controlling part for controlling a position of the slider part in an X axis direction and a Y axis direction; and a yawing correcting part for correcting a yawing of the slider part around a Z axis.

In the XY stage, the plurality of slider parts each comprises a rolling/pitching correcting part for correcting a change in a Z axis direction of the slider part.

In the XY stage, the plurality of slider parts each comprises: a sensor part for detecting a change in the Z axis direction of the slider part; and a coil part for restraining a change in the Z axis direction based on a detected value by the sensor part.

In the XY stage, the plurality of slider parts each comprises: a sensor part for detecting a change in the Z axis direction; and an orthogonal current providing part for providing correction currents each having a phase orthogonal to phase angles of respective control currents supplied to an X axis motor for moving the slider part in the X axis direction and a Y axis motor for moving the slider part in the Y axis direction based on a detected value by the sensor part.

In the XY stage, the plurality of slider part each comprises a ripple restraining part for restraining a ripple due to a cogging thrust generated at the slider part by a cogging correcting signal calculated from a commutation phase angles of respective control currents supplied to an X axis motor for moving the slider part in the X axis direction and a Y axis motor for moving the slider part in the Y axis direction in accordance with a speed of the slider part.

The XY stage comprises a constant number setting part for changing at least one of constant numbers of the commutation phase angle and the cogging correcting signal.

In the XY stage, the cogging correcting signal of the X axis is added to the cogging correcting signal of the Y axis, and the cogging correcting signal of the Y axis is added to the cogging correcting signal of the X axis.

In the XY stage, the cogging correcting signal of the X axis and the cogging correcting signal of the Y axis are added to a cogging correcting signal of the Z axis.

In the XY stage, the plurality of slider part each comprises: a speed feedback controlling part for controlling a speed by a feedback control based on a moving speed of the slider part; and an acceleration feedback controlling part for controlling an acceleration by a feedback control based on the moving speed of the slider part.

In the XY stage, an acceleration instructing value of the slider part outputted by the speed feedback controlling part is provided to the acceleration feedback controlling part as a feed-forward signal.

In the XY stage, the plurality of slider parts each comprises a dead time correcting part for superposing correction currents, whose phases are orthogonal to respective control currents supplied to an X axis motor for moving the slider part in the X axis direction and the Y axis motor for moving the slider part in the Y axis direction, with the respective control currents.

In the XY stage, a value of the correction current is manually set in accordance with a characteristic of a dead time generating circuit.

In the XY stage, the plurality of slider parts is each mounted with a device carrying out an alignment in a semiconductor fabricating apparatus and a device carrying out an exposure in the semiconductor fabricating apparatus.

**ADVANTAGEOUS EFFECTS OF THE INVENTION**

According to the XY stage, the following effects are achieved and a positioning accuracy requested when the XY stage is used in an exposure step of a semiconductor fabricating apparatus can be realized.

(1) A positioning error by rotation (yawing) around a Z axis is restrained when a two-dimensional position of the slider part is controlled, which can contribute to promotion of the positioning accuracy.

(2) A change in the slider part in a Z axis direction (a variation in a distance between the slider part and a lattice platen), that is, rolling or pitching is restrained, which can contribute to promotion of the positioning accuracy.

(3) A ripple of a position control generated by a cogging thrust generated in synchronism with a commutator period of an alternating current control current supplied to a face motor is restrained, which can contribute to promotion of the positioning accuracy.

(4) A disturbance of a motor thrust caused by a thrust, a thrust ripple or the like by cogging is restrained without changing a characteristic of a speed control loop by adopting an acceleration control loop, which can contribute to promotion of the positioning accuracy:

(5) A dead zone by a dead time generating circuit is corrected, a deterioration in a control characteristic of a motor caused by a current distortion or a response delay in a case of a small current is restrained, which can contribute to promotion of the positioning accuracy.

BRIEF DESCRIPTION OF THE DRAWINGS

[Fig. 1] is a perspective view showing an embodiment of an XY stage to which the invention is applied

[Fig. 2] is a perspective view of an XY stage showing other embodiment of the invention

[Fig. 3] is a function block diagram for explaining a two-dimensional position control system representatively showing a slider part 101.

[Fig. 4] is a function block diagram for explaining a specific constitution of respective elements constituting an XY servo driver and arrangements of X1, X2 motors, Y1, Y2 motors mounted to a slider part.

[Fig. 5] is a function block diagram for explaining other embodiment of a two-dimensional position control system representatively showing the slider part 101.

[Fig. 6] is an image view for explaining pitching, rolling phenomena of a slider part moved by being floated up above a lattice platen.

[Fig. 7] (A) is a plane view of a lattice platen and a slider part, (B) is a side view in an X axis direction.

[Fig. 8] is a function block diagram showing basic constitution examples of a pitching angle servo part, a rolling angle servo part, a positioning servo part.

[Fig. 9] (A) is a plane view of a lattice platen and a slider part, (B) is a side view in an X axis direction.

[Fig. 10] is a characteristic diagram for explaining a phase of a control current supplied to an X axis motor and a Y axis motor.

[Fig. 11] is an image view for controlling pitching (or rolling) of a slider part by supplying different orthogonal currents to diagonally arranged X1 motor and X2 motor (or Y1 motor and Y2 motor).

[Fig. 12] is an image view for controlling a position of a slider part in a Z axis direction by supplying orthogonal currents having the same phase and the same value to diagonally arranged X1 motor and X2 motor (or Y1 motor and Y2 motor).

[Fig. 13] is a plane view showing a standard arrangement of a motor.

[Fig. 14] is a plane view of arranging X1 through X4 motors and Y1 through Y4 motors at 8 regions excluding a center region by dividing a region by 9 as an arrangement of the motor mounted to a slider.

[Fig. 15] is a function block diagram showing a specific constitution example of a pitching angle servo part, a rolling angle servo part, a Z axis position servo part.

[Fig. 16] is a function block diagram showing an X axis position control servo system of a slider part including a ripple restraining part.

[Fig. 17] is a function block diagram showing an embodiment of adding cogging correcting signals of respective axes to cogging correcting signals of other axes.

[Fig. 18] is a function block diagram showing the position control servo system including an acceleration feedback controlling part with regard to an X1 motor.

[Fig. 19] is a function block diagram showing a position control system provided with a dead time correcting part with regard to an X1 motor.

[Fig. 20] is a plane view showing a constitution of an XY stage having a plurality of slider parts disclosed in JP-A-2002-116239.

[Fig. 21] is a function block diagram for explaining a two-dimensional position control system of a slider part.

## DESCRIPTION OF THE REFERENCE NUMERALS AND SIGNS

| | |
|---|---|
| 100 | lattice platen |
| 101, 102, 103 | slider parts |
| 104, 105, 106 | device holders |
| 107, 107', 107" | devices |
| 108 | camera |
| 109 | laser light source |
| 110 | photomask |
| 111 | lens system |
| 112, 113, 114 | yawing correcting parts |

## BEST MODE FOR CARRYING OUT THE INVENTION

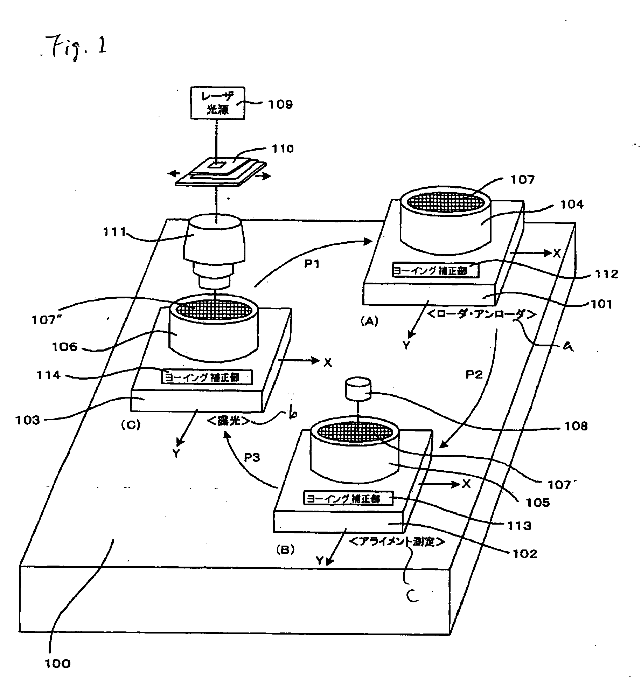

Embodiments of the invention will be explained in details in reference to the drawings as follows. Fig. 1 is a perspective view showing an embodiment of an XY stage to which the invention is applied. In Fig. 1, numeral 100 designates the lattice platen. Numeral 101 designates the slider part at (A) position, numeral 102 designates a slider part at (B) position, numeral 103 designates the slider part at (C) position, positions of which are controlled in two-dimensional directions (X, Y) above an upper face of the lattice platen 100.

Numeral 104 designates the device holder formed at the slider part 101, numeral 105 designates the device holder formed at the slider part 102, numeral 106 designates the device holder formed at the slider part 103, and the device holders are mounted with the devices 107, 107', 107" constituting objects of inspection.

Numerals 112, 113, 114 designate the yawing correcting parts respectively provided to the slider parts 101, 102, 103.

The slider part 101 at (A) position carries out a load/unload step and is brought into a state of moving the slider part at (C) position finished with an exposure step. Here, the device finished with exposure is unloaded and the new exposure object device 107 is loaded.

At this occasion, simultaneously, at the slider part 102 at (B) position, an alignment measurement of the device 107' loaded at a preceding exposure cycle is carried out by the camera 108, at the slider part 103 at (C) position, exposure of the device 107" loaded in the preceding exposure cycle and finished with the alignment measurement is carried out.

In exposure, a slit-like beam from the laser light source 109 is irradiated to the device by way of the photomask 110 and the lens system 111. Exposure to respective chips of the device is carried out by controlling to move the photomask 110 and the slider part 103 relative to each other, it is an indispensable condition for fabricating a semiconductor having a highly integrated density that a positional accuracy of controlling to move the both members is high accuracy with excellent balance.

When exposure at (C) position has been finished, the slider part 103 at the (C) position is moved to (A) by a path of an arrow mark P1 to proceed to the unload/load step, the slider part 101 at (A) position is moved to (B) position by a path of an arrow mark P2 to proceed to the exposure step. The rotation is repeated as follows.

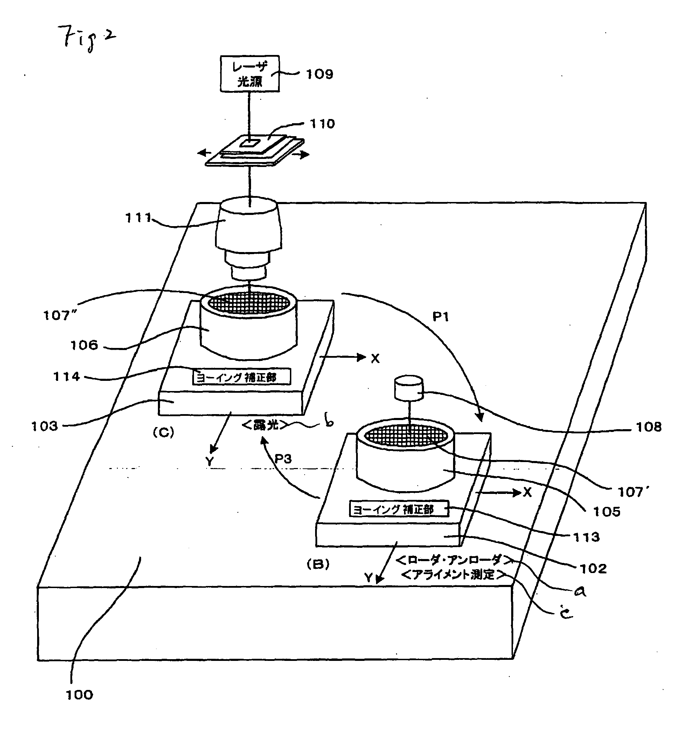

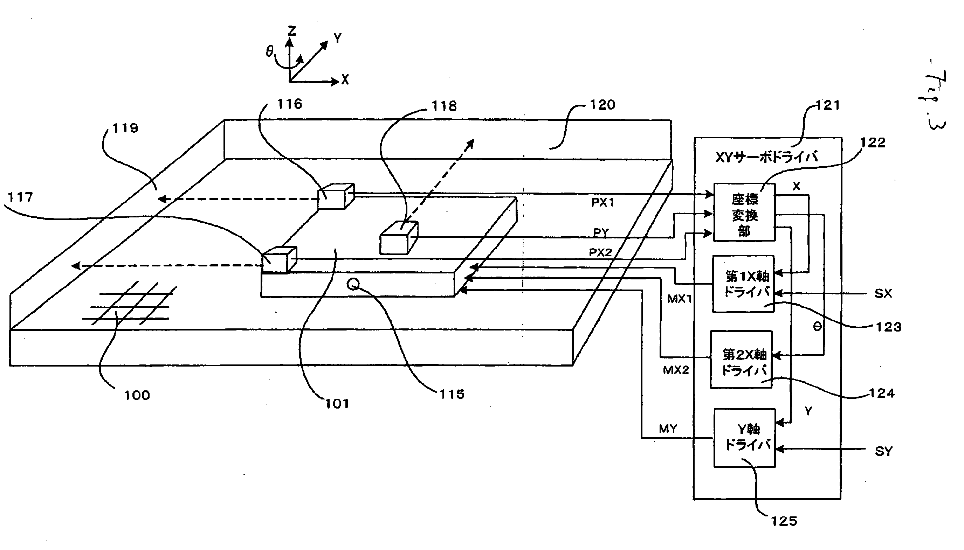

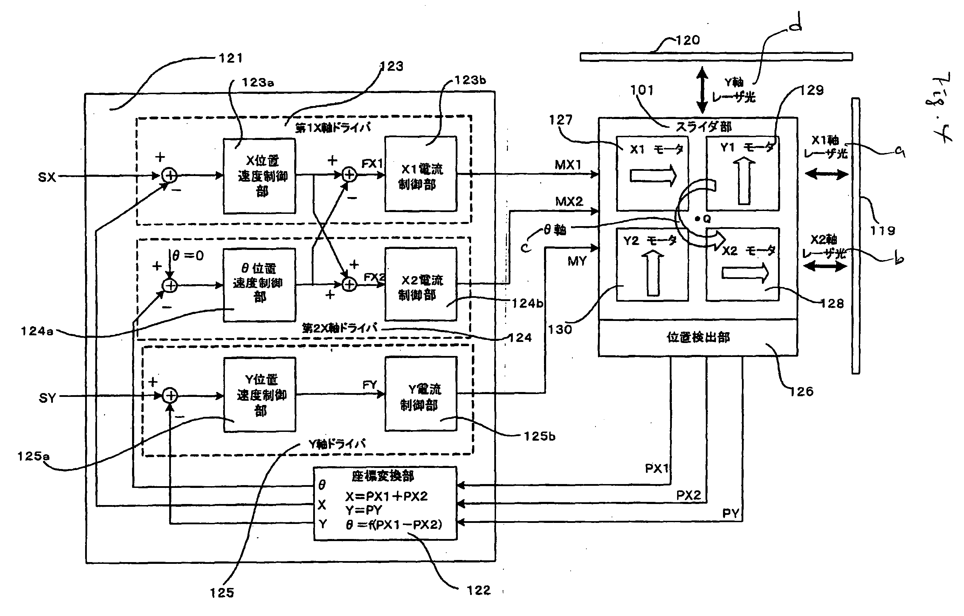

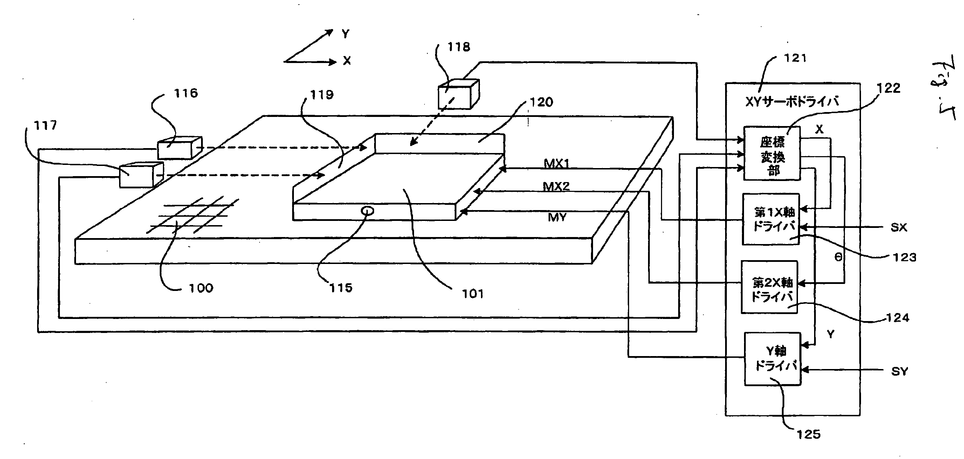

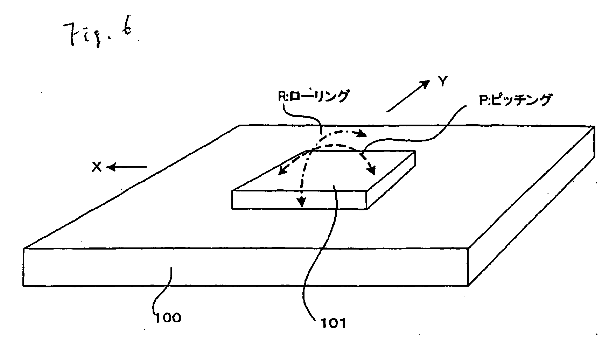

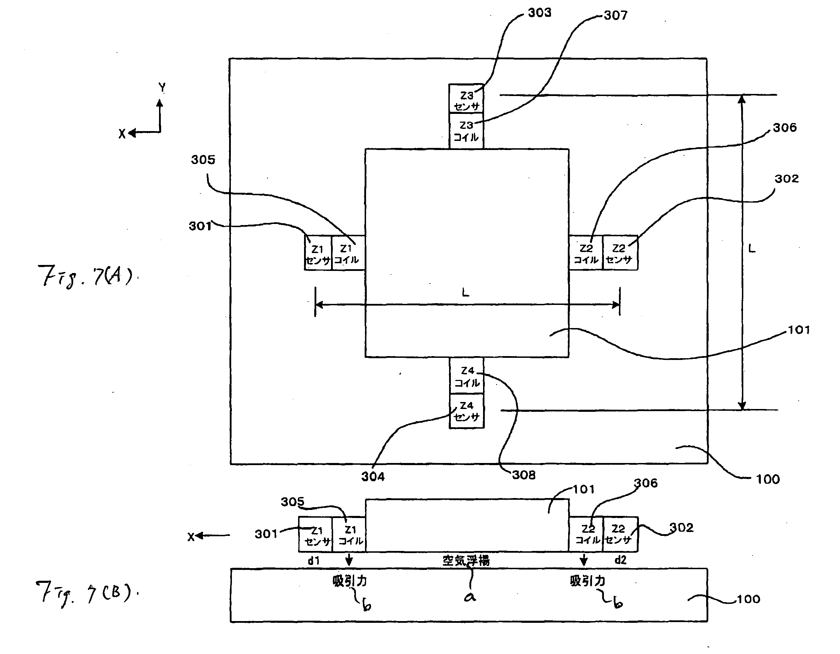

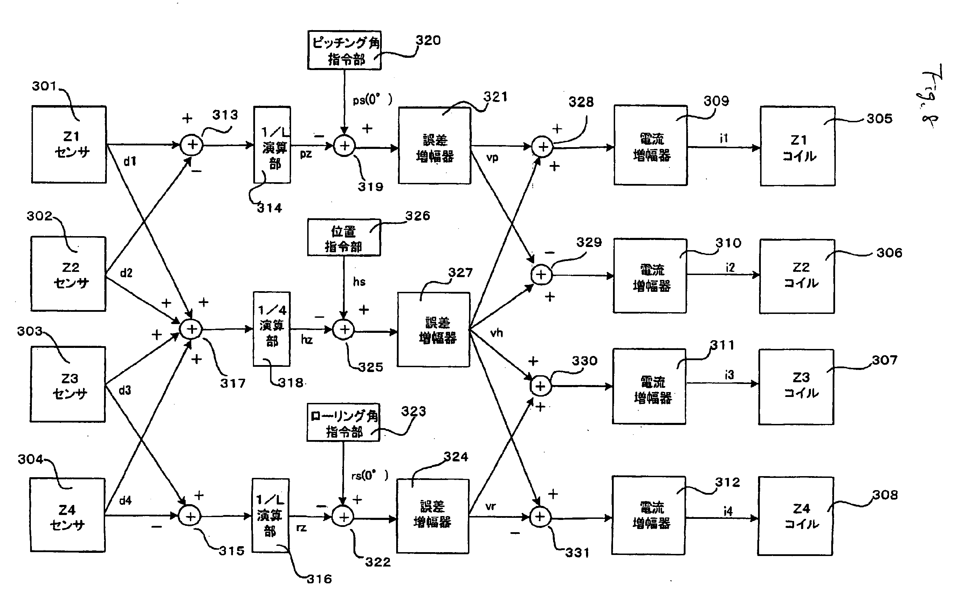

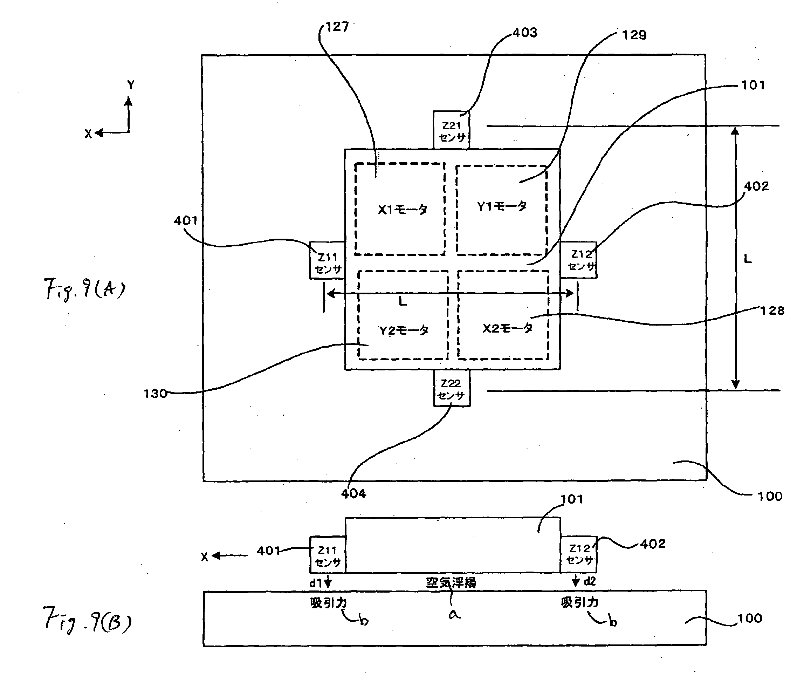

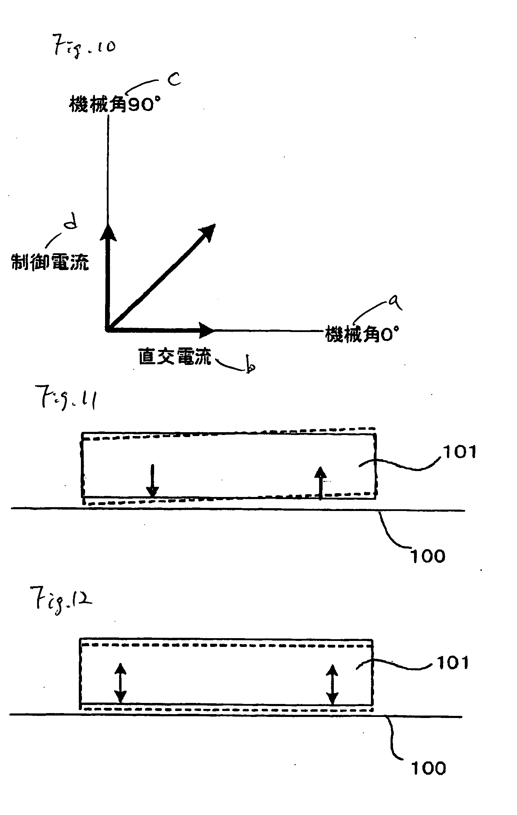

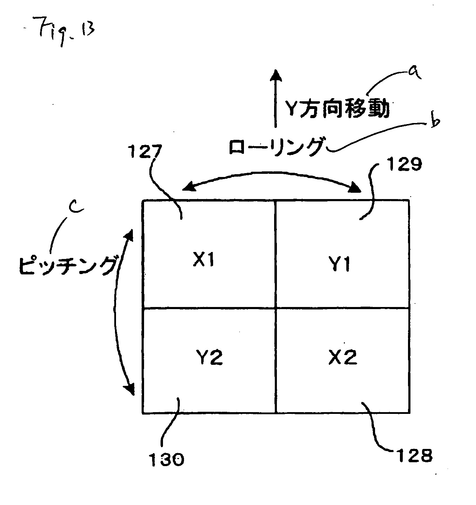

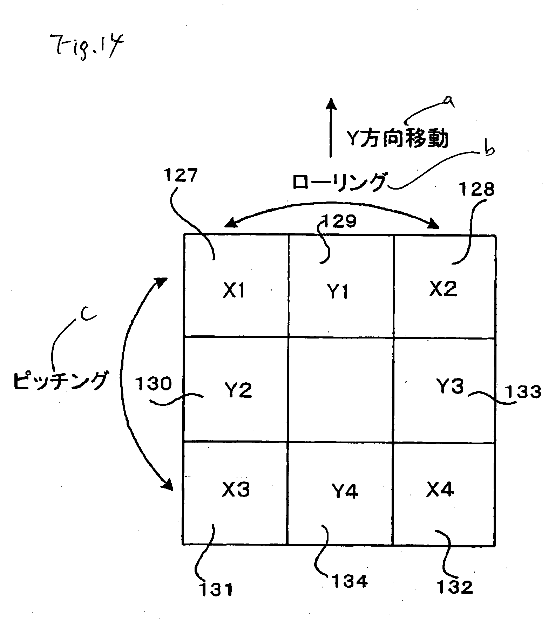

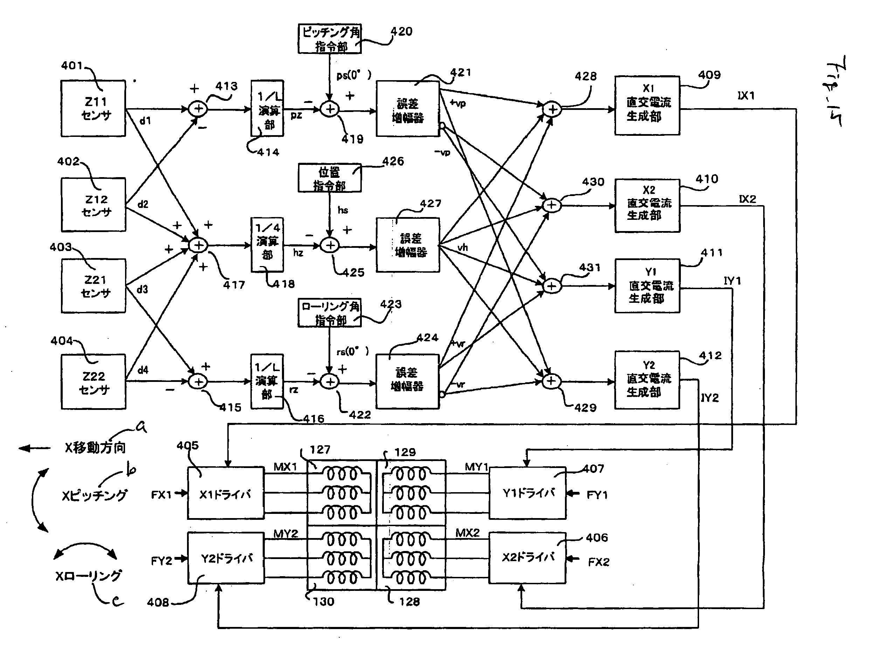

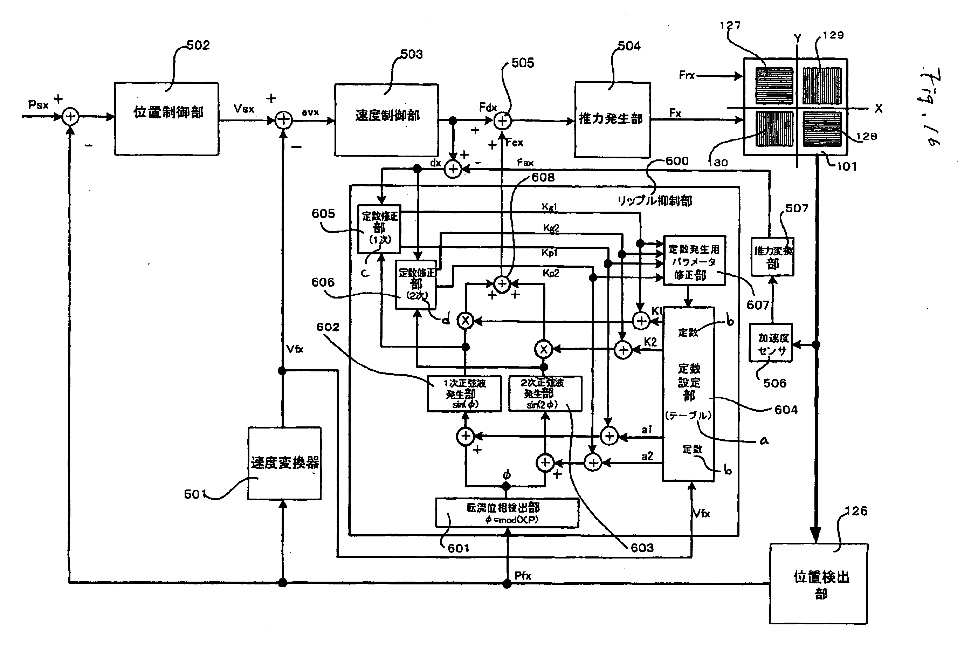

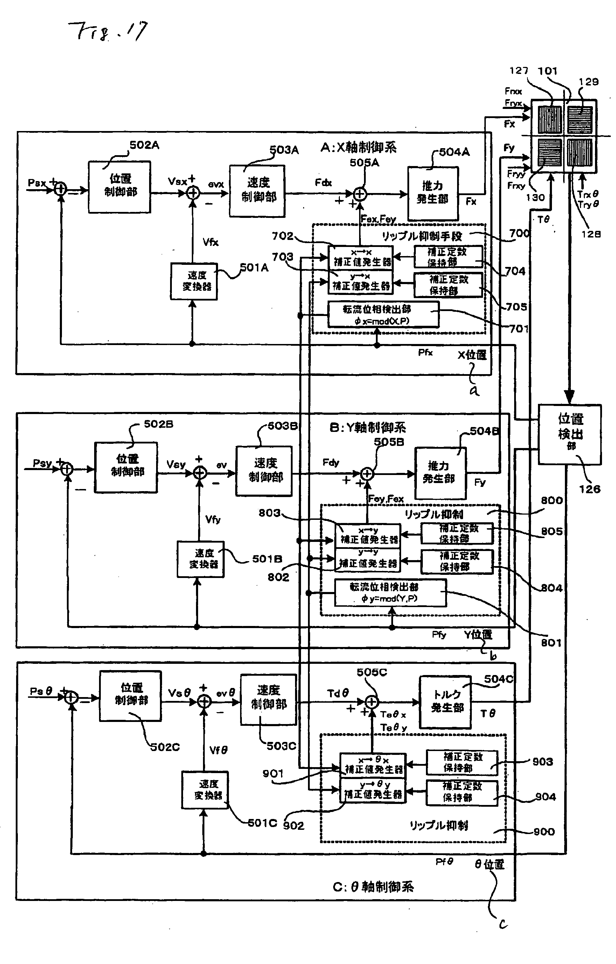

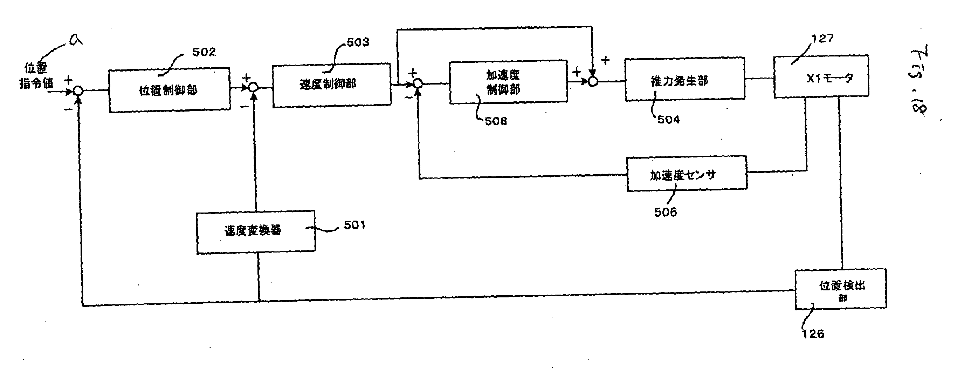

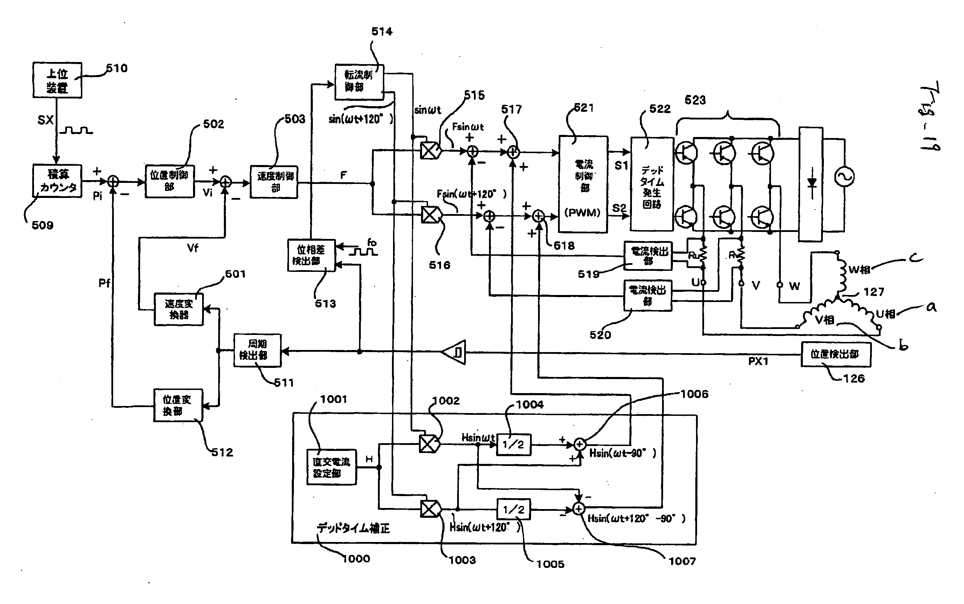

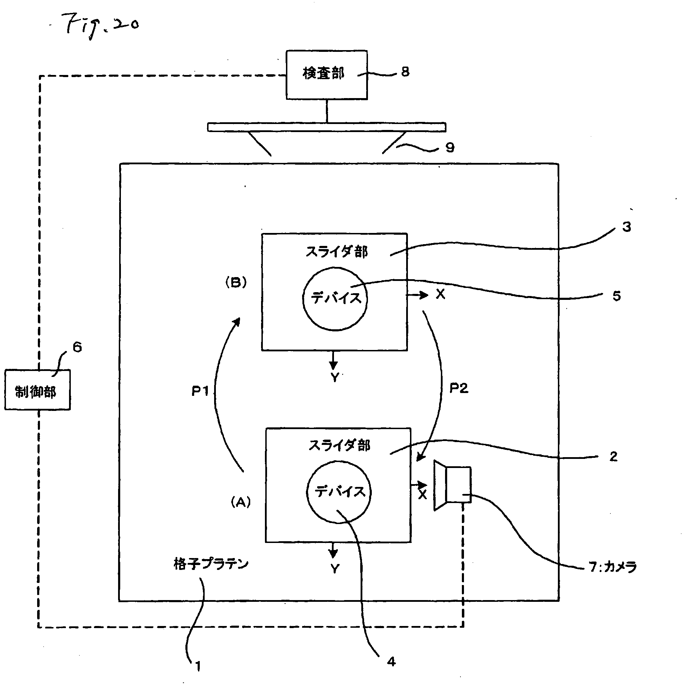

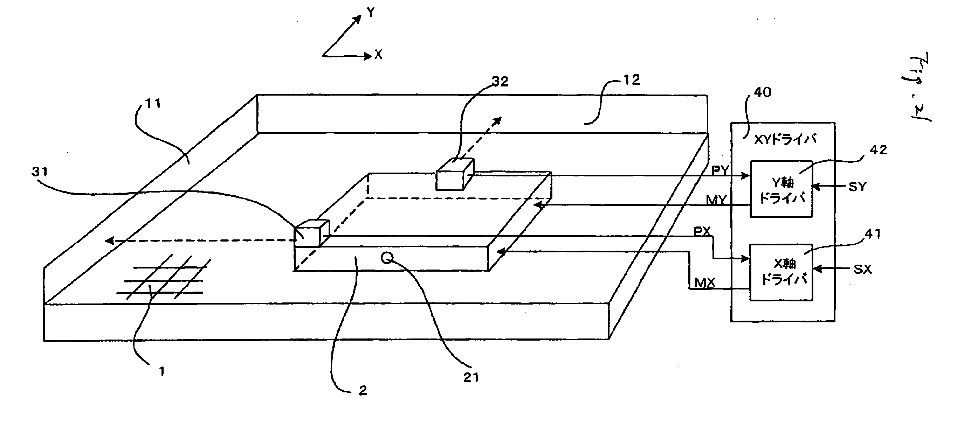

Fig. 2 is a perspective view of an XY stage showing other embodiment of the invention. A characteristic point in comparison with Fig. 1 resides in that the slider part 102 at (B) position carries out the load/unload step and the alignment step at the same position. By such a constitution of 2 slider parts, lead around of a cable connection (not illustrated) to the respective slider parts and a design of an interferometer are facilitated to contribute also to a reduction in cost of the system.

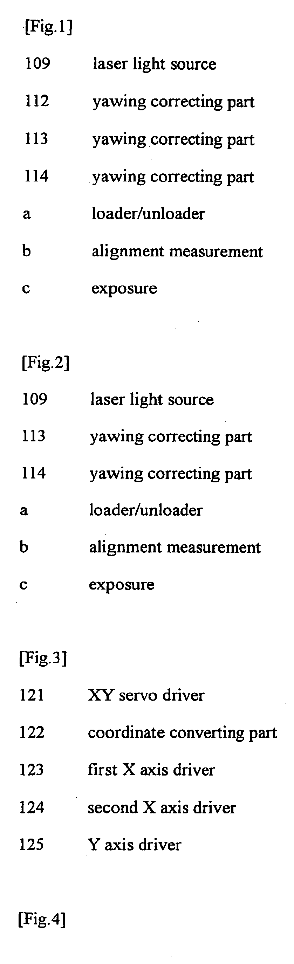

Fig. 3 is a function block diagram for explaining a two-dimensional position control system representatively shown by the slider part 101. A difference thereof from the two-dimensional position control system explained in reference to Fig. 21 resides in providing the yawing correcting part for carrying out a correction for a rotation θ around a Z axis. A function and a constitution of the yawing correcting part will be explained as follows.

A float up part 115 formed at the lattice platen 100 and the slider part 101 are the same as the constitution of the lattice platen 1 and the float up part 15 of Fig. 21. A characteristic portion of the invention will be explained as follows.

Numerals 116 and 117 designate a first X axis sensor and a second X axis sensor arranged to be fixed at an upper portion of the slider part 101 placed at a predetermined distance in X direction. Numeral 118 designates a Y axis sensor similarly arranged to be fixed to the upper portion of the slider part 101.

Numeral 119 designates an X axis mirror having a predetermined height arranged to be fixed to one end portion of X axis of the lattice platen 100 orthogonally to X axis and is opposed to the first axis sensor 116 and the second axis sensor 117. Numeral 120 designates a Y axis mirror having a predetermined height arranged to be fixed to one end portion of Y axis of the lattice platen 100 orthogonally to Y axis and is opposed to the Y axis sensor 118.

The first X axis sensor 116, the second X axis sensor 117 and the Y axis sensor 118 are optical distance measuring apparatus for measuring positions in X direction and Y direction of the slider part 101 by irradiating laser beams to the X axis mirror 119 and the Y axis mirror 120, receiving reflected light and measuring moving distances by utilizing interference. Notations PX1 and PX2 designate X axis direction distance measured values by the first X axis sensor 116 and the second axis sensor 117, and notation PY designates a Y direction distance measured value by the Y axis sensor 118.

A block 121 is an XY servo driver comprising a coordinate converting part 122, a first X axis driver 123, a second Y axis driver 124, a Y axis driver 125. The coordinate converting part 122 inputs the measured values PX1, PX2, and PY and respectively outputs a measured coordinate X to the first X axis driver 123, outputs a yawing rotation angle (rotation of Z axis) θ to the second axis driver 124, and outputs a measured coordinate Y to the Y axis driver 125.

The first X axis driver 123 calculates a deviation between the measured coordinate X and a target position signal SX provided from a higher apparatus and outputs a control current MX1 to an X1 motor realized by a face motor mounted on the slider part 101.

The second X axis driver 124 calculates a deviation between the yawing rotation angle θ and a set value 0° and outputs a control current MX2 to an X2 motor mounted to the slider part 101. The Y axis driver 125 calculates a deviation between the measured coordinate Y and a target position signal SY provided from a higher apparatus and outputs a control current MY common to a Y1 motor and a Y2 motor mounted to the slider part 101.

Fig. 4 is a function block diagram for explaining specific constitutions of respective elements constituting the XY servo driver 121 and arrangements of X1, X2 motors, Y1, Y2 motors mounted to the slider part 101.

As a content of calculation of the coordinate converting part 122, the measured coordinate X is outputted by addition of the measured values PX1 and PX2 from a position detecting part 126. The measured value PY is outputted as a measured coordinate Y as it is. The Z axis rotation angle, that is, the yawing angle θ is calculated by a calculation of a predetermined function by a subtraction value of the measured values PX1 and PX2 to be outputted.

The first X axis driver 123 comprises an X axis speed control part 123a for inputting a deviation between the target position signal SX and the measured coordinate X, and an X1 current control part 123b for receiving a thrust instruction FX1 thereof and outputting the control current MX1 to the X1 motor 127 of the slider part 101.

The second X axis driver 124 comprises a θ position speed control part 124a for inputting a deviation between the yawing angle θ and set value 0° and an X2 current control part 124b for receiving a thrust instruction FX2 thereof and outputting the control current MX2 to the X2 motor 128 of the slider part 101.

The Y axis driver 125 comprises a Y position speed control part 125a for inputting a deviation between the target position signal SY of the measured coordinate Y and a Y current control part 125b for receiving a thrust instruction FY and outputting the control current MY common to the Y1 motor 129 and the Y2 motor 130.

The output of the X position speed control part 123a is added to the output of the θ position speed control part 124a and is inputted to the X2 current control part 124b as the thrust instruction FX2. The output of the θ position speed control part 124a is subtracted from the output of the X position speed control part 123a and is inputted to the X1 current control part 123b as the thrust instruction FX1.

X1, X2, Y1, Y2 motors mounted to the slider part 101 are arranged such that X1, X2 motors and Y1, Y2 motors are diagonal to each other relative to a center point Q, and when X1 motor and X2 motor receive control currents different from each other, a rotational force is generated around the Z axis centering on Q point, which constitutes an operating force for restraining yawing of X axis.

Detailed structures of X1 motor, X2 motor, Y1 motor, Y2 motor mounted to the slider part 101, a constitution of a position control servo system and the like are disclosed in details in JP-A-2000-65970, and therefore, an explanation thereof will be omitted.

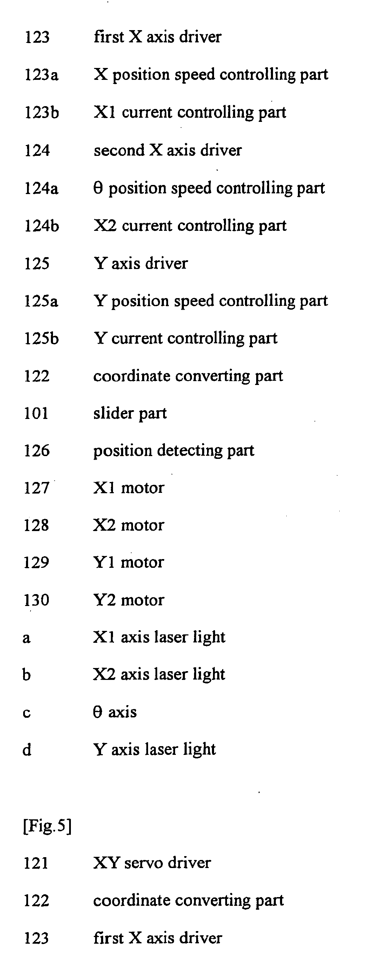

Fig. 5 is a function block diagram for explaining other embodiment of a two-dimensional position control system representatively shown by the slider part 101. A difference in view of a constitution from Fig. 3 resides in that the first X axis sensor 116, the second X axis sensor 117, the Y axis sensor 118 are arranged to be fixed, and the X axis mirror 119 and the Y axis mirror 120 are formed on a side of the slider part 101.

By a constitution in which the sensor of the interferometer is not mounted to the slider part 101 in this way, the following effect can be expected.

(1) 2 pieces of the X axis sensors and 1 piece of the Y axis sensor are separated from the slider part and is arranged to be fixed, and therefore, it is avoided that heat generation by electronic parts thereof effects an influence on the work attached above the slider part and the device mounted above the work. Thereby, when the work carries out an operation of positioning the device with higher accuracy and the like as in the exposure step, a temperature compensation is dispensed with, a constitution above the slider part is simplified, which can contribute to a reduction in cost.

(2) Since 3 pieces of the sensors are arranged to be fixed to external portions, movable lead around of a power source cable, a signal cable to the slider part which has been needed in the XY stage is dispensed with, which can contribute to a reduction in cost of cable processing.

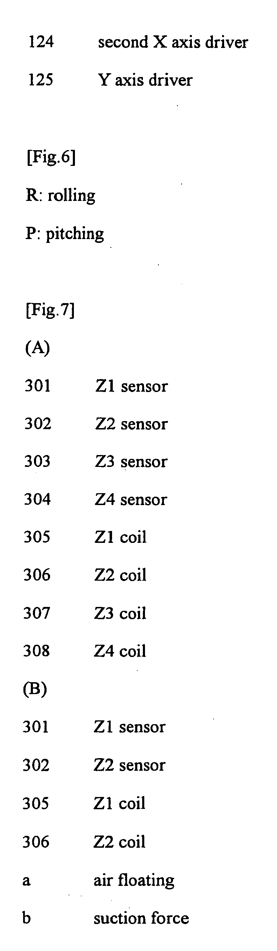

Next, pitching and rolling correction applied to the invention will be explained. Fig. 6 is an image view for explaining pitching and rolling phenomena of the slider part 101 moved by being floated up above the lattice platen 100. A rocking P in X direction designated by an arrow mark of a dotted line is pitching and a rocking R in Y direction designated by an arrow mark of a one-dotted chain line orthogonally thereto is rolling.

When the device mounted to the slider part 101 requests an extremely high positional accuracy as in the exposure step or the like, a correction of restraining pitching and rolling of the slider part 101 floated up to move becomes indispensable. According to the technology described in JP-2000-65970, although yawing constituting rotation in the Z axis direction of the slider part can be restrained, pitching and rolling cannot be dealt with.

Fig. 7(A) is a plane view of the lattice platen 100 and the slider part 101, Fig. 7(B) is a side view in X axis direction (Y axis direction sensor is not illustrated). The slider part 101 is floated up above the upper face of the lattice platen 100 with a small clearance therebetween by injecting compressed air. The float up part per se is not provided with a function of controlling the clearance constant, and therefore, pitching and rolling explained in reference to Fig. 6 are brought about in accordance with a movement of the slider part 101.

AZ1 sensor 301 and a Z2 sensor 302 are distance meters attached to both end portions in the X axis direction of the slider part 101, forming a first Z axis sensor for detecting a pitching angle in the X axis direction of the slider part. Similarly, a Z3 sensor 303 and a Z4 sensor 304 are distance meters attached to both end portions in the Y axis direction of the slider part 101, forming a second Z axis sensor for detecting a rolling angle in the Y axis direction of the slider part.

As shown by Fig. 7(B), the Z1 sensor 301 and the Z2 sensor 302 measure distances d1 and d2 between the slider part 101 and the lattice platen 100 at the sensor positions. Although not illustrated, similarly, the Z3 sensor 303 and the Z4 sensor 304 measure distances d3 and d4 between the slider part 101 and the lattice platen 100 at the sensor positions.

A distance between the Z 1 sensor 301 and the Z2 sensor 302 and a distance between the Z3 sensor 303 and the Z4 sensor 304 are constituted by the same distance L. The pitching angle is detected based on the distance measured values d1 and d2 of the Z1 sensor 301 and the Z2 sensor 302 and the distance L in X direction of the slider part. Similarly, a rolling angle in Y direction of the slider part is detected based on the measured values d3 and d4 of the Z3 sensor 303 and the Z4 sensor 304 and the distance L in Y direction of the slider part.

The pitching angle pz and the rolling angle rz are approximately calculated by the following equations.

$$pz = (d1 - d2)/L \qquad (1)$$

$$rz = (d3 - d4)/L \qquad (2)$$

Further, a Z direction average distance hz between the slider part 102 and the lattice platen 100 is calculated by the following equation based on the measured values d1 through d4 of 4 pieces of the distance meters.

$$hz = (d1 + d2 + d3 + d4)/4 \qquad (3)$$

AZ1 coil 305 and a Z2 coil 306 are respectively provided proximately to the Z1 sensor 301 and the Z2 sensor 302 to form a first Z axis coil. Similarly, a Z3 coil 307 and a Z4 coil 308 are provided respectively proximately to the Z axis sensor 303 and the Z4 sensor 304 to form a second Z axis coil. By making exciting currents flow to the coils, as shown by Fig. 7(B), a suction force is generated between the slider part 101 and the lattice platen 100 and the distance d1 through d4 of the clearances can individually be controlled.

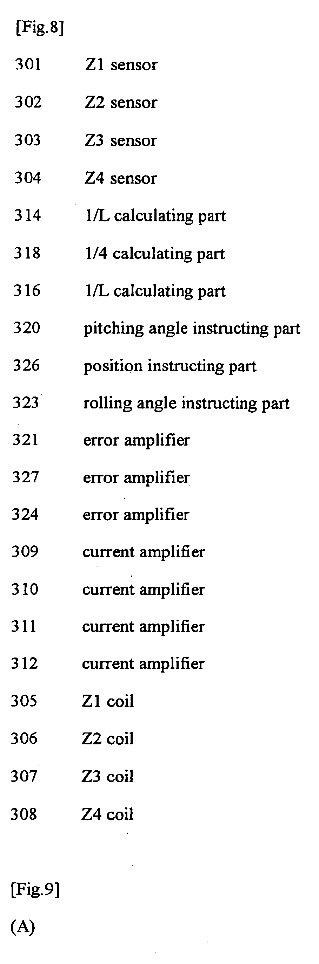

Fig. 8 is a function block diagram showing basic constitution examples of a pitching angle servo part, a rolling angle servo part, a potion servo part. Numerals 309 through 122 designate current amplifiers, respectively supplying exciting currents i1 through i4 for servo control to the Z1 coil 305 through Z4 coil 308.

A difference between the measured value d1 of the Z1 sensor 301 and the measured value d2 of the Z2 sensor 302 is calculated by a subtractor 313 and the pitching angle pz in Equation (1) is calculated by a 1/L calculating part 314. A difference between the measured value d3 of the Z3 sensor 303 and the measured value d4 of the Z4 sensor 304 is calculated by a subtractor 315 and the rolling angle rz of Equation (2) is calculated by a 1/L calculating part 116. The measured values d1 through d4 of the Z1 sensor through the Z4 sensor are added by an adder 317 and the position hz of Equation (3) is calculated by a 1/4 calculating part 318.

A subtractor 319 provides a difference between the pitching angle measured value pz and a set value ps (0°) of a pitching angle instructing part 320 to an error amplifier 321. A subtractor 322 provides a difference between the rolling angle measured value rz and a set value rs (0°) of a rolling angle instructing part 323 to the error amplifier 324. A subtractor 325 provides a difference between the position measured value hz and a set value hs of a position instructing part 326 to an error amplifier 327.

An output vp of the error amplifier 321 for controlling the pitching angle is provided to the current amplifiers 309 and 310 by way of an adder 328 and a subtractor 329 to control the pitching angle pz to be null by reversibly controlling the exciting currents i1 and i2 of the Z1 coil 305 and the Z2 coil 306.

Similarly, an output vr of the error amplifier 324 for controlling the rolling angle is provided to the current amplifiers 311 and 312 by way of an adder 330 and a subtractor 331, and controls the rolling angle rz to be null by reversibly operating the exciting currents i3 and i4 of the Z3 coil 307 and the Z4 coil 308.

An output vh of the error amplifier 327 for controlling the position of the slider is provided to the current amplifiers 309 through 312 by way of the adders 328, 330 and the subtractors 329, 3131 and controls the distance hz between the slider part 101 and the lattice platen 100 to be the set value hs by operating the exciting currents i1 through i4 of the Z1 coil through the Z4 coil.

An accuracy of restraining the pitching angle and the rolling angle can be promoted by providing the position servo part for making the position (distance hz in Z axis direction) of the slider part in addition to the pitching angle servo part and the rolling angle servo part in this way.

Next, other embodiment of controlling to restrain the pitching angle and the rolling angle will be explained in reference to Fig. 9(A) through Fig. 15. A characteristic of the embodiment resides in individually controlling the distances d1 through d4 of the clearances by generating an attraction force between the slider part 101 and the lattice platen 100 by superposing the control current of the X axis motor or the Y axis motor mounted to the slider part with a correction current a phase of which is orthogonal to a phase of the control current based on the detected measured values of the pitching angle pz and the rolling angle rz as well as the z axis direction average distance hz.

Fig. 9(A) is a plane view of the lattice platen 100 and the slider part 101, Fig. 9(B) is a side view in the X axis direction (Y axis direction sensor is not illustrated). The slider part 101 is floated up above the upper face of the lattice platen 100 with a small clearance therebetween by injecting compressed air. The float up part per se is not provided with the function of controlling the clearance constant, and therefore, the pitching and rolling explained in reference to Fig. 6 are generated in accordance with movement of the slider part.

A Z11 sensor 401 and a Z12 sensor 402 are distance meters attached to both end portions in the X axis direction of the slider part 101, forming a first Z axis sensor for detecting the pitching angle in the X axis direction of the slider part. Similarly, a Z21 sensor 403 and a Z22 sensor 404 are distance meters attached to both end portions in the Y axis direction of the slider part 101, forming a second Z axis sensor for detecting the rolling angle in the Y axis direction of the slider part.

As shown by Fig. 9(B), the Z11 sensor 401 and the Z12 sensor 402 measure distances d1 and d2 between the slider part 101 and the lattice platen 100 at sensor positions. Although not illustrated, similarly, the Z21 sensor 403 and the Z sensor 404 measure distances d3 and d4 between the slider part 101 and the lattice platen 100 at sensor positions. The principle of the distance measurement is the same as that of the embodiment of Fig. 7(A) and Fig. 7(B).

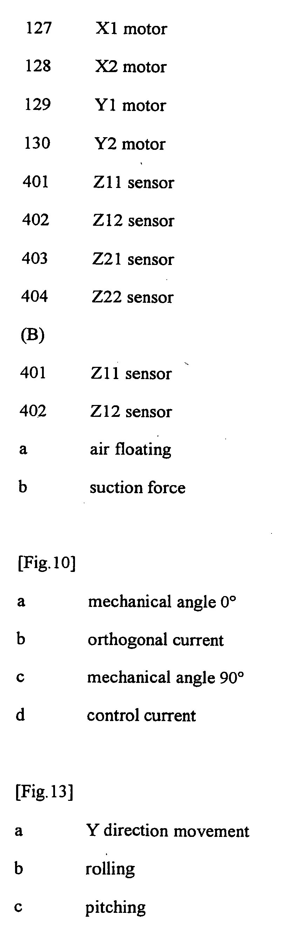

Fig. 10 is a characteristic diagram for explaining the phase of the control current supplied to the X axis motor and the Y axis motor. Although in a mode of use of the background art, the phase is set to a machine angle 90° generating the thrust the most, the invention is characterized in superposing a current (orthogonal current) which does not generate the thrust of a machine angle 0° (a position at which positions of teeth of the motor and teeth of the platen coincide with each other) orthogonal to the face of the control current.

The suction force of the motor is determined by a sum of a magnetic flux of a bias magnet and a magnetic flux by a current, and therefore, the suction force can be controlled by the orthogonal current. Further, an amount of floating up a plane motor using the air float up part is determined by a balance between the suction force and a repulsion force of air, and therefore, the float up amount can be controlled by the suction force ($\propto$ orthogonal current).

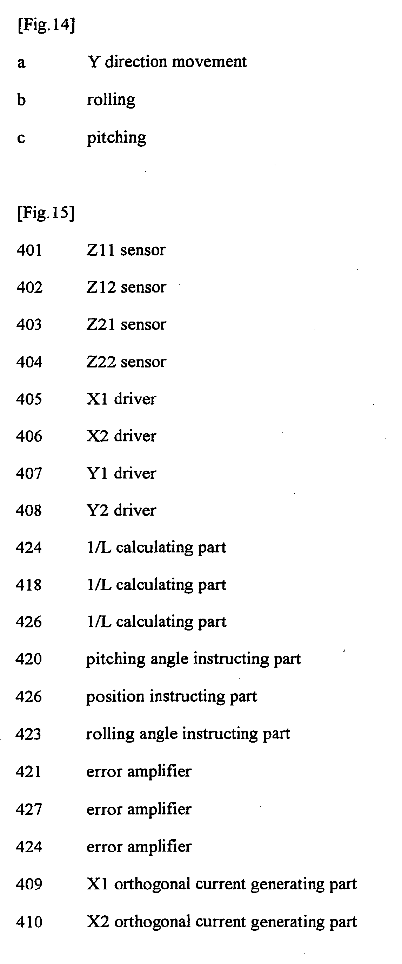

Fig. 11 is an image view for controlling pitching (or rolling) of the slider part 101 by supplying orthogonal currents different from each other to the X1 motor and the X2 motor (or Y1 motor and Y2 motor) diagonally arranged by utilizing the principle.

Fig. 12 is an image view for controlling the position of the slider part 101 in the Z axis direction by supplying orthogonal currents having the same phase and the same value to the X1 motor and the X2 motor (or Y1 motor and Y2 motor) diagonally arranged by similarly utilizing the principle.

Fig. 13 is a plane view showing a standard arrangement of motors. In the case of such a motor arrangement, an attitude is controlled by making orthogonal currents flow by the following combinations.

(1) Pitching direction control: orthogonal currents having inverse phases are made to flow by X1 motor, Y2 motor and Y1 motor, X2 motor.
(2) Rolling direction control: orthogonal currents having inverse phases are made to flow in X1 motor, Y1 motor and Y2 motor, X2 motor.
(3) Z axis direction position control: orthogonal currents having the same phase and the same value are made to flow in all motors.

Fig. 14 shows a plane view dividing a region by 9 as an arrangement of motors mounted to a slider, and arranging X1 through X4 motors and Y1 through Y4 motors at 8 regions excluding a center region. Numeral 131 and 132 designate an X3 motor and an X4 motor. Numerals 133 and 134 designate a Y3 motor and a Y4 motor. By providing 8 axes of current supply parts in this way, a motor mainly generating a thrust and a motor mainly generating a suction force are separated depending on a moving direction to be able to facilitate the control.

When controlled by an X motor which does not generate the thrust in a moving direction,

(1) pitching direction control: orthogonal currents having inverse phases are made to flow by X1, X2 and X3, X4.
(2) rolling direction control: orthogonal currents having inverse phases are made to flow by X1, X3 and X2, X4.
(3) Z axis direction position control: orthogonal currents having the same phase are made to flow by X1 through X4.

Fig. 15 is a function block diagram showing specific constitution examples of a pitching angle servo part, a rolling angle servo part, a Z axis position servo part. Numeral 405 designates an X1 driver, numeral 406 designates an X2 driver, numeral 407 designates a Y1 driver, numeral 408 designates a Y2 driver, for respectively inputting thrust instructions FX1, FX2 and thrust instructions FY1, FY2 and outputting 3 phases of control currents MX1, MX2 and MY1, MY2 to an X1 motor 127, an X2 motor 128 and a Y1 motor 129, a Y2 motor 130.

Numeral 409 designates an X1 orthogonal current generating part, numeral 410 designates an X2 orthogonal current generating part, numeral 411 designates a Y1 orthogonal current generating part, numeral 412 designates a Y2 orthogonal current generating part, for outputting orthogonal currents IX1, IX2 and IY1, IY2 to the X1 driver 405, the X2 driver 406 and the Y2 driver 407, the Y2 driver 408. The orthogonal currents IX1, IX2 and IY1, IY2 are superposed on the control currents MX1, MX2 and MY1, MY2 of 3 phases.

A difference between a measured value d1 of the Z11 sensor 401 and a measured value d2 of the Z12 sensor 402 is calculated by a subtractor 413, and a pitching angle pz of Equation (1) is calculated by a 1/L calculating part 414.

A difference between a measured value d3 of the Z21 sensor 403 and a measured value d4 of the Z22 sensor 404 is calculated by a subtractor 415, and a rolling angle rz of Equation (2) is calculated by a 1/L calculating part 416.

The measured values d1 through d4 of the Z11 sensor through the Z22 sensors are added by an adder 417, and an average position hz in the Z axis direction of Equation (3) is calculated by a 1/4 calculating part 418.

A constitution of the pitching angle servo part will be explained. A subtractor 419 provides a deviation between the pitching angle measured value pz and a set value ps (0°) of the pitching angle instruction part 420 to an error amplifier 421 for controlling the pitching angle. An output vp of the error amplifier 421 is provided to the X1 orthogonal current generating part 409 and the Y2 orthogonal current generating part 412 by way of an adder 428 and an adder 429.

An inverse phase output -vp of the error amplifier 421 is provided to the X2 orthogonal current generating part 410 and the Y1 orthogonal current generating part 411 by way of an adder 430 and an adder 431. By such a servo system, the X1 motor, the Y2 motor and the X2 motor, the Y1 motor are operated to rotate by phases inverse to each other and controlled such that the pitching angle pz becomes null.

A constitution of the rolling angle servo part will be explained. A subtractor 422 provides a deviation between the rolling angle measured value rz and a set value rs (0°) of the rolling angle instructing part 423 to an error amplifier 424 for controlling the rolling angle. An output vr of the error amplifier 424 is provided to the X1 orthogonal current generating part 409 and the Y1 orthogonal current generating part 411 by way of the adder 428 and the adder 431.

An inverse output -vr of the error amplifier 424 is provided to the X2 orthogonal current generating part 410 and the Y2 orthogonal current generating part 412 by way of the adder 430 and the adder 429. By such a servo system, the X1 motor, the Y1 motor and the X2 motor, the Y2 motor are operated to rotate by phases inverse to each other and controlled such that the rolling angle rz becomes null.

A constitution of the Z direction position servo part will be explained. A subtractor 425 provides a deviation between the Z axis direction average position measured value hz and the set value hs of the position instructing part 426 to an error amplifier 427 for controlling the Z axis direction position. An output vh of the error amplifier 427 is commonly provided to the adders 428 through 431, the X1 motor, the Y1 motor and the X2 motor, the Y2 motor are operated by the same phase and controlled such that the distance between the slider part 101 and the lattice platen 100 becomes the set value hz.

An accuracy of restraining the pitching angle and the rolling angle can be promoted by providing the Z axis direction position servo part for making the position of the slider part (distance in Z axis direction) constant in addition to the pitching angle servo part and the rolling angle servo part in this way.

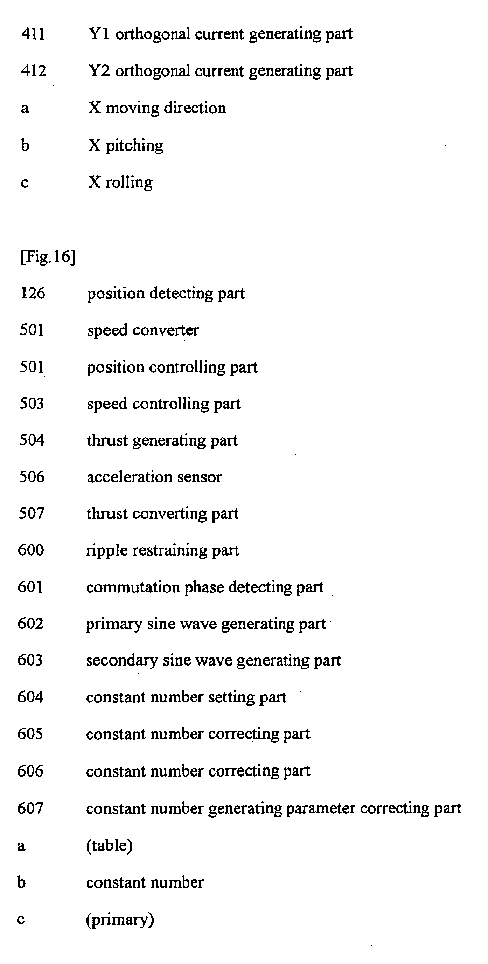

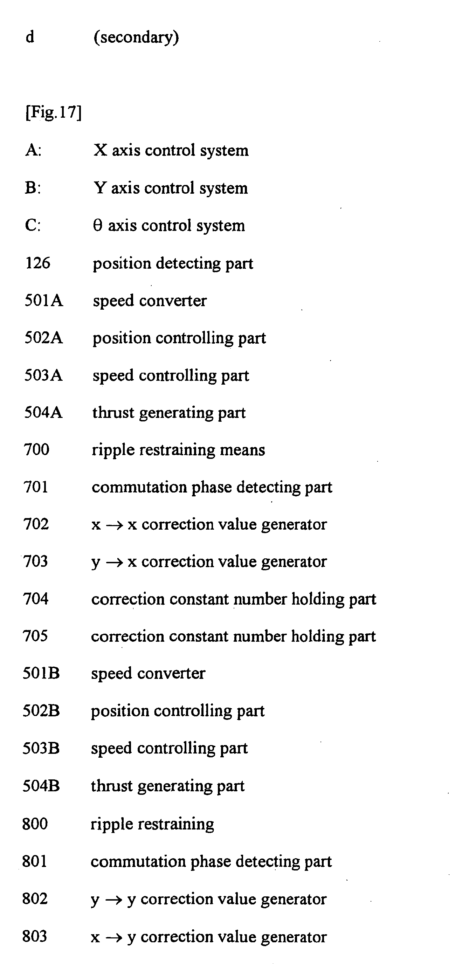

Next, an explanation will be given of restraining a rippled caused by a cogging thrust in reference to Fig. 16 and Fig. 17.
Fig. 16 is a function block diagram showing an X axis position control servo system of the slider part 101 having a ripple restraining part 600.

Numeral 501 designates a speed converter for calculating a speed detecting value Vfx by calculating a speed of the slider part 101 from a signal component of a position detecting value Pfx of an X axis provided from the position detecting part 126 of the slider part 101. Also with regard to the speed converter, details thereof are disclosed in JP-A-2000-65970, and an explanation of a content thereof will be omitted.

Numeral 502 designates a position controlling part for outputting a speed instruction value Vsx by processing to calculate a deviation between a position instruction value Psx and the position detecting value Pfx. Numeral 503 designates a speed control part for outputting a thrust instruction value Fdx by processing to calculate a deviation evx between the speed instruction value Vsx and the speed detecting value Vfx.

Numeral 504 designates a thrust generating part for inputting the thrust instruction value Fdx and a cogging correcting signal Fex from the ripple restraining part 600 mentioned later added to by an adding part 505, supplying alternating current control currents to the X1 motor 127 and the X2 motor 128 of the slider part 101 and generates a thrust Fx in an X axis direction. With regard to the thrust generating part, details thereof are also disclosed in JP-A-2000-65970, and therefore, an explanation of a content thereof will be omitted.

With regard to the X motor and the Y motor provided at the slider part 101, a so-to-speak hybrid type face motor for supplying alternating control currents to a plurality of cores opposed to grooves of a lattice platen formed by a magnetic member to generate a thrust between the core and the lattice platen is advantageous in view of response performance and cost and is frequently adopted.

As a weak point of the hybrid type face motor, there poses a problem that a ripple is superposed in position control of the slider part 101 by a cogging thrust Frx generated in synchronism with a commutation period of the alternating control current supplied to the motor, constituting one factor of deteriorating an accuracy of the position control.

The block 600 in a dotted line is a ripple restraining part of the invention for calculating the cogging correcting signals Fex having an amplitude the same as that of the cogging thrust and a phase inverse thereto and adding the cogging correcting signal Fex to the thrust instruction value Fdx by the adding part 505 to thereby restrain the cogging thrust Frx from being generated.

In the ripple restraining part 600, numeral 601 designates a commutator phase detecting part. A commutation phase angle $\phi$ is calculated as follows from a position X provided from the position detecting value Pfx with regard to the X axis and a core pitch P of the X axis motor by mod function for calculating a remainder of division.

$$\phi = \mathrm{mod}\,(X, P)$$

Numeral 602 designates a primary sine wave generating part for generating $\sin(\phi)$ by inputting the commutation phase angle $\phi$. Numeral 603 designates a secondary sine wave generating part for generating $\sin(2\phi)$ by inputting the commutation phase angle $\phi$. 3 order, 4 order...n order sine wave generating parts can be provided as necessary.

Numeral 604 designates a constant number setting part for inputting detecting value Vfx of the speed converter 501 and calculating to set optimum values of constants a1, a2 and k1, k2 in correspondence with the speed Vfx. Although the calculation may be carried out by a calculation of a function by a pertinent algorism, it is general to construct a constitution of reading constants from a table corresponding speed detecting values and optimum constants divided by a pertinent resolution.

Numeral 506 designates an acceleration sensor attached to the slider part 101, numeral 507 designates a thrust converting part for calculating a thrust predicted value Fax including the cogging thrust operated to the slider part 101 based on a detecting value of the acceleration sensor 506. The thrust predicted value Fax is subtracted from the thrust instruction value Fdx of the speed control part 503 to calculate a difference dx.

Numeral 605 designates a constant correcting part with regard to a primary sine wave for inputting the difference dx and an output of the primary sine wave generating part 602, comparing amplitudes and phases of the both, generating a signal kp1 for correcting the constant a1 and a signal kg1 for correcting the constant k1 based on amplitude errors and phase errors and respectively adding the signals to a1 and k1 .

Similarly, numeral 606 designates a constant correcting part with regard to the secondary sine wave for inputting the difference dx and an output of the sine wave generating part 603, comparing amplitudes and phases of the both, generating a signal kp2 for correcting the constant a2 and a signal kg2 for correcting the constant k2 based on the amplitude errors and the phase errors and respectively adding the signals to a2 and k2.

Numeral 607 designates a constant generating parameter correcting part for inputting the correcting signals kp1, kg1 and kp2, kg2 of the constant correcting parts 605 and 606, correcting parameters for generating the constants at the constant number setting part 604 and correcting the constants al, a2 and k1, k2.

Numeral 608 designates an adding part for adding the output of the primary sine wave generating part 602 and the output of the secondary sine wave generating part 603 subjected to the processing of correcting the constants, calculating the cogging correcting signal Fex having the amplitude the same as that of the cogging thrust and the phase inverse thereto, adding the signal to the thrust instruction value Fdx by an adding part 505 to thereby restrain the cogging thrust Frx from being generated.

A cogging correction effect can be promoted by a feedback control for feeding back the predicted thrust Fax operated to the slider part 101 and calculating the amplitude errors, the phase errors of the sine wave generating parts for the respective orders by the difference dx from the thrust instruction value Fdx to correct the constant set values.

Further, by correcting the parameters for generating the constants of the constant number setting part 604 in reference to differences between the correction signals kp1, kg1 and kp2, kg2 after the feedback control and the set constants a1, a2 and k1, k2, tuning can be carried out for the constant number setting part 604 an accuracy of which is high by a learning effect.

Although an embodiment of applying the ripple restraining part 600 to the X axis has been explained as described above, by also providing similar ripple restraining parts to respective axes of a Y axis and a $\theta$ axis, ripples of the respective axes by the cogging thrust can effectively be restrained.

However, according to the XY stage using the phase motors, there are interferences from other axes, the cogging thrusts operated to the respective axes also interfere with other axes, and therefore, the cogging cannot completely be corrected by independent ripple restraining parts for the respective axes.

Fig. 17 is a function block diagram showing an embodiment of adding cogging correcting signals for respective axes to cogging correcting signals of other axes. A region A of a chain line is an X axis control system, B is a Y axis control system, C designates a θ axis control system, and thrusts Fx, Fy and a torque Tθ are operated from the respective control systems to the slider part 101.

The thrust Fx of the X axis is operated with a cogging thrust Frxx of its own axis and a cogging thrust Fryx by an interference of the Y axis. Similarly, the thrust Fy of the Y axis is operated with a cogging thrust Fryy of its own axis and a cogging thrust Frxy by an interference of the X axis. Further, the torque Tθ of the θ axis is operated with cogging thrusts Trxθ and Tryθ by interferences of the X axis and the Y axis.

The position detecting part 126 outputs an X axis position detecting value Pfx, a Y axis position detecting value Vfy, a θ axis position Pfθ of the slider part 101 to provide to respective axes control systems. Notations 502A, 502B, 502C designate position controlling parts of the respective axis control systems for calculating deviations between position instruction values Psx, Psy, Psθ of the respective axes and the position detecting values Pfx, Pfy, Pfθ and outputting speed instruction values Vsx, Vsy, Vsθ.

Deviations evx, evy, evθ between speed detecting values Vfx, Vfy, Vfθ of speed converters 501A, 501B, 501C of the respective axes and speed instruction values Vsx, Vsy, Vsθ of the respective axes are calculated by speed control parts 503A, 503B, 503C of the respective axes, and thrust instruction values Fdx, Fdy of X, Y axes and a torque instruction value Tdθ of the θ axis are outputted.

The thrust instruction values of the respective axes are added with cogging correcting signals from ripple restraining parts of the respective axes by adding parts 505A, 505B, 505C of the respective axes and inputted to thrust generating parts 504A, 504B of X, Y and a torque generating part 504C of the θ axis, converted into thrusts Fx, Fy and the torque Tθ and operated to the slider part 101.

A block 700 of a dotted line is the ripple restraining part of the X axis and constituted by a commutator phase detecting part 701 of its own axis, a correction value generator 702 for the cogging thrust of its own axis, a correction value generator 703 for the cogging thrust by an interference from the Y axis, and constant holding parts 704, 705 for the correction value generators.

A block 800 of a dotted line is the ripple restraining part of the Y axis and constituted by a commutator phase detecting part 801 of its own axis, a correction value generator 802 for the cogging thrust of its own axis, a correction value generator 803 for the cogging thrust by an interference from the X axis, and constant holding parts 804, 805 for the correction value generators.

A block 900 of a dotted line is the ripple restraining part of the θ axis and constituted by a commutator phase detecting part 901 for the cogging thrust by an interference from the X axis, a correction value generator 902 for the cogging thrust by an interference from the Y axis, and constant holding parts 903, 904 for the correction value generators.

Commutator phase respective outputs φx of the commutator phase detecting part 701 of the X axis are outputted to the correction value generator 702 of its own axis and also outputted to the correction value generator 803 of the Y axis and the correction value generator 901 of the θ axis. Similarly, commutator phase respective outputs φy of the commutator phase detecting part 801 of the Y axis are outputted to the correction value generator 802 of its own axis and also outputted to the correction value generator 703 of the X axis and the correction value generator 902 of the θ axis.

Cogging correction values Fex and Fey of the correction value generators 702 and 703 of the X axis are added and added to the thrust instruction value Fdx by the adding part 505A. Similarly, cogging correction values Fey and Fex of the correction value generators 802 and 803 of the Y axis are added and added to the thrust instruction value Fdy by the adding part 505B. Similarly, cogging correction values Teθx and Teθy of the correction value generators 901 and 902 of the θ axis are added and added to the torque instruction value Tdθ by the adding part 505C.

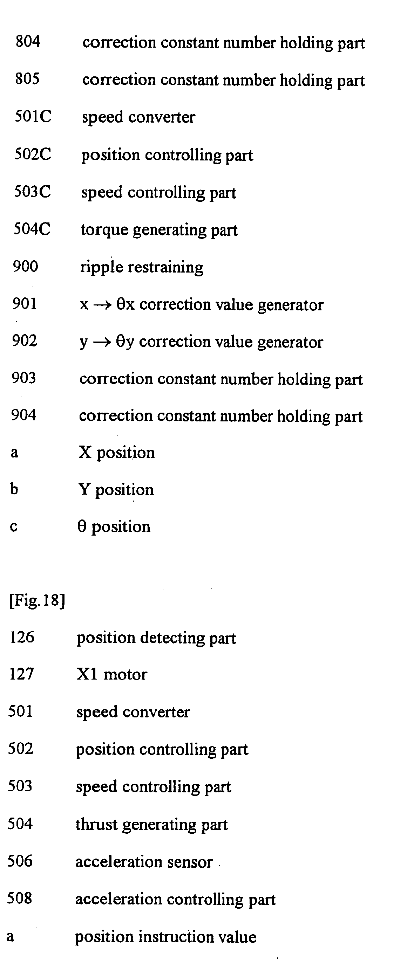

Fig. 18 is a function block diagram showing a position control servo system having an acceleration feedback controlling part with regard to the X1 motor. The position controlling part 502 outputs a control signal for controlling the X1 motor 127 to an instructed position by a feedback control based on the deviation between the position instruction value and the position detecting value of the position detecting part 126. The speed converter 501 converts the position detecting signal of the position detecting part 126 into the speed detecting value.

The speed control part 503 outputs a control signal for controlling a speed of moving the X1 motor 127 by a feedback control based on a deviation between the speed instruction value from the position controlling part 502 and the speed detecting value from the speed converter 501.

Te thrust generating part 504 drives the X1 motor 127 based on the control signal from the speed control part 503. The thrust generating part 504 is provided with a PWM circuit for generating a pulse width modulating signal (PWM signal) for operating a control current of a motor coil, an inverter circuit of a bridge type for driving a motor based on the PWM signal and the like.

In a case of providing a speed control loop to a control loop of controlling a two-dimensional position of the slider part, when a loop gain is small, a variation is brought about in the speed detecting value to constitute a disturbance of the motor thrust caused by the thrust by the cogging, the thrust ripple or the like. When the gain is increased, in a case in which a signal delay in the loop is large, or in a case in which a mechanical system resonance is present in the motor, the loop is resonated, and therefore, a restriction is brought about in the gain, which constitutes a factor of hampering promotion of a positioning accuracy.

According to the invention, in order to resolve the problem, for reducing an influence by a disturbance of the motor thrust without changing a characteristic of the speed control loop, an acceleration control loop is provided in addition to the position control loop and the speed control loop.

An acceleration sensor 506 detects an acceleration of the X1 motor 127. An acceleration control part 508 controls an acceleration of moving the X1 motor 127 based on a deviation between an acceleration instructing value from the speed control part 503 and an acceleration detecting value from the acceleration sensor 506. A control output of the acceleration control part 508 is provided to the thrust generating part 504.

Further, there is provided a signal path for making an acceleration instructing value outputted by the speed control part 503 bypass the acceleration control part 508, the bypassed acceleration instructing value is added to the output of the acceleration control part 508 as a feed-forward signal. Thereby, the acceleration is controlled by a feed-forward control.

At this occasion, the characteristic of the speed control loop can be set so as not to be effected with an influence of the acceleration control loop by reducing an influence of a disturbance thrust by adjusting a gain (acceleration constant) when the acceleration is converted into the acceleration detecting value. Thereby, the influence by the disturbance by the thrust of the motor caused by the thrust by the cogging, the thrust ripple or the like can be reduced without changing the characteristic of the speed control loop.

Fig. 19 is a function block diagram showing a position control servo system provided with a dead time correcting part with regard to the X1 motor. Numeral 509 designates an accumulating counter for accumulating a target position signal SX provided from a higher apparatus 510 by a pulse number to convert into a digital target position signal Pi.

Numeral 511 designates a period detecting part for inputting the position detecting signal PX1 of the position detecting part 126 and calculating a period thereof Numeral 512 designates a position converting part, numeral 501 designates a speed converter for acquiring a period signal from the period detecting part 511 to convert into a position signal Pf and a speed signal Vf. With regard to an operational principle thereof, details thereof are disclosed in JP-A-2000-65970, and therefore, an explanation thereof will be omitted here.

Numeral 502 designates the position controlling part for calculating a deviation between the target position signal Pi and the position signal Pf and outputting a speed instruction signal Vi. Numeral 503 designates a speed control part for calculating a deviation between the speed instruction signal Vi and the speed signal Vf and outputting a thrust instruction F.

Numeral 513 designates a phase difference detecting part for detecting a phase difference between the position detecting signal PX1 and a scanning period fo to output to a commutator control part 514. Signals of $\sin\omega t$ and $\sin(\omega t + 120°)$ of the output of the commutator control part 514 and the thrust instruction F are respectively multiplied by multipliers 515 and 516 to output $F\sin\omega t$ and $F\sin(\omega t + 120°)$.

Deviations between outputs of the multipliers and detecting signals of current detecting parts 519 and 520 are inputted to a current control part 521. The current control part 521 calculates the deviations and outputs switching signals S1 and S2 subjected to a pulse width modulation (PWM), controls to open and close a 3 phase switching circuits 523 by way of a dead time generating circuit 522 and supplies control currents to U phase, V phase, W phase coils of the X1 motor 127 realized by a face motor of 3 phases.

The current detecting part 519 detects a voltage drop of a current detecting resistor Ru connected in series with the U phase coil to feed back to the current control part 521. Similarly, the current detecting part 520 detects a voltage drop of a current detecting resistor Rv connected in series with the V phase coil to feed back to the current control part 521. Feedback is not carried out for the W phase coil.

Details of the PWM current control for the phase motor of 3 phases by the commutator control are disclosed in JP-A-2000-65970, and therefore, a detailed explanation thereof will be omitted here.

Here, the dead time generating circuit 522 adds dead time of a predetermined time period at a timing of switching the switching signals such that the switching signals S1 and S2 are not made ON simultaneously to prevent burning by a large current of the 3 phase switching circuit 523 by being made ON simultaneously.

Although the dead time generating circuit 522 is an element necessary for preventing burning by a large current of the switching circuit, there is a current distortion or a delay in response when a small current is outputted to the motor by an influence of a dead zone by the dead time to pose a problem of deteriorating a control characteristic of the motor by generating a small amplitude.

Although when a request for an accuracy of the position control of the slider is not severe so much, the characteristic deterioration does not pose a problem, according to a positioning apparatus having an ultra high accuracy as in an exposure step of mounting a positioning apparatus with a higher accuracy onto the slider, a small amplitude constitutes a factor of hampering a request accuracy of positioning.

A block 1000 of a dotted line is a dead time correcting part introduced by the invention. Numeral 1001 designates an orthogonal current setting part for outputting a current instruction H for determining a correcting current to be superposed. The value can be set manually by an operator arbitrarily in accordance with a characteristic of the dead time generating circuit 522.

Numerals 1002, and 1003 designate multipliers for outputting $H\sin\omega t$ and $H\sin(\omega t +120°)$ by multiplying the signals of $\sin\omega t$ and $\sin(\omega t + 120°)$ of the output of the commutator control part 514 by the orthogonal current instruction H.

A signal of $H\sin(\omega - 90°)$ signal is generated by adding a signal constituted by operating the output $H\sin\omega t$ of the multiplier 1002 by a multiplication of 1/2 by an operator 1004 and the output $H\sin(\omega t + 120°)$ of the multiplier 103 by an adding part 1006. The signal is superposed on a deviation signal on a side of $F\sin\omega t$ by an adder 517 provided on an input side of the current control part 521.

Similarly, a signal of $H\sin(\omega t + 120° - 90°)$ is generated by adding a signal constituted by operating the output $H\sin(\omega t + 120°)$ of the multiplier 1003 by a multiplication of 1/2 by the operator 1004 and the output of $H\sin\omega t$ of the multiplier 1002 by an adding part 1007 in a inverse phase. The signal is superposed on the deviation signal on the side of the $F\sin(\omega t + 120°)$ by an adder 518 provided on the input side of the current control part 521.

By introducing the dead time correcting part, the small amplitude by the influence of the dead time can effectively be avoided. A correction current value to be superposed can manually be set in accordance with the characteristic of the dead time generating circuit, and therefore, a tuning operation for optimizing the control accuracy is facilitated.

In the embodiments explained above, an explanation has been given of various kinds of correcting parts for making the effect of promoting the position control accuracy remarkable when the XY stage having a plurality of slider parts is applied to the semiconductor fabricating apparatus. However, an object of applying the invention is not limited to the semiconductor fabricating apparatus but is generally applicable to an XY stage requesting a high accuracy of an inspecting apparatus, an integrating apparatus or the like.

**Claims**

**1.** An XY stage for controlling a position of a slider part on a lattice platen in two-dimensional directions, the XY stage comprising
a plurality of the slider parts whose positions are controlled independently,
wherein the plurality of the slider parts each comprises:

a position controlling part for controlling a position of the slider part in an X axis direction and a Y axis direction; and
a yawing correcting part for correcting a yawing of the slider part around a Z axis.

**2.** The XY stage according to claim 1,
wherein the plurality of slider parts each comprises a rolling/pitching correcting part for correcting a change in a Z axis direction of the slider part.

**3.** The XY stage according to claim 2,
wherein the plurality of slider parts each comprises:

a sensor part for detecting a change in the Z axis direction of the slider part; and
a coil part for restraining a change in the Z axis direction based on a
detected value by the sensor part.

**4.** The XY stage according to claim 2,
wherein the plurality of slider parts each comprises:

a sensor part for detecting a change in the Z axis direction;
and
an orthogonal current providing part for providing correction currents each having a phase orthogonal to phase angles of respective control currents supplied to an X axis motor for moving the slider part in the X axis direction and a Y axis motor for moving the slider part in the Y axis direction based on a detected value by the sensor part.

**5.** The XY stage according to claim 1,
wherein the plurality of slider part each comprises a ripple restraining part for restraining a ripple due to a cogging thrust generated at the slider part by a cogging correcting signal calculated from a commutation phase angles of respective control currents supplied to an X axis motor for moving the slider part in the X axis direction and a Y axis motor for moving the slider part in the Y axis direction in accordance with a speed of the slider part.

**6.** The XY stage according to claim 5,
which comprises a constant number setting part for changing at least one of constant numbers of the commutation phase angle and the cogging correcting signal.

**7.** The XY stage according to claim 5,
wherein the cogging correcting signal of the X axis is added to the cogging correcting signal of the Y axis, and the cogging correcting signal of the Y axis is added to the cogging correcting signal of the X axis.

**8.** The XY stage according to claim 5,

wherein the cogging correcting signal of the X axis and the cogging correcting signal of the Y axis are added to a cogging correcting signal of the Z axis.

9. The XY stage according to claim 1, wherein the plurality of slider part each comprises:

   a speed feedback controlling part for controlling a speed by a feedback control based on a moving speed of the slider part; and
   an acceleration feedback controlling part for controlling an acceleration by a feedback control based on the moving speed of the slider part.

10. The XY stage according to claim 9, wherein an acceleration instructing value of the slider part outputted by the speed feedback controlling part is provided to the acceleration feedback controlling part as a feed-forward signal.

11. The XY stage according to claim 1, wherein the plurality of slider parts each comprises a dead time correcting part for superposing correction currents, whose phases are orthogonal to respective control currents supplied to an X axis motor for moving the slider part in the X axis direction and the Y axis motor for moving the slider part in the Y axis direction, with the respective control currents.

12. The XY stage according to claim 11, wherein a value of the correction current is manually set in accordance with a characteristic of a dead time generating circuit.

13. The XY stage according to claim 1, wherein the plurality of slider parts is each mounted with a device carrying out an alignment in a semiconductor fabricating apparatus and a device carrying out an exposure in the semiconductor fabricating apparatus.

Fig. 1

Fig 2

レーザ
光源 ～109

110

111

107″

106

114

ヨーイング 補正部

103

100

(C)

<露光> ～b

P3

X

Y

P1

108

107′

105

113

102

a

こ

ヨーイング 補正部

(B)

<ローダ・アンローダ>
<アライメント測定>

Y

X

Fig. 3

Fig. 4

EP 1 852 763 A1

Fig. 5

Fig. 6

R:ローリング

Y

P:ピッチング

X

100

101

Fig. 7(A).

Fig. 7(B).

Fig. 8

Fig. 9 (A)

Fig. 9 (B)

Fig.10

機械角90° c

d
制御電流

機械角0° a

直交電流 b

Fig.11

101

100

Fig.12

101

100

Fig. 13

Fig.14

Y方向移動  *a*

ローリング  *b*

127  129  128

| X1 | Y1 | X2 |

ピッチング  *c*

130  Y2  Y3  133

X3  Y4  X4

131  134  132

Fig. 15

Fig. 16

Fig. 17

Fig.18

Fig. 19

Fig. 20

Fig. 21

[Fig.1]

| 109 | laser light source |
|-----|--------------------|
| 112 | yawing correcting part |
| 113 | yawing correcting part |
| 114 | yawing correcting part |
| a | loader/unloader |
| b | alignment measurement |
| c | exposure |

[Fig.2]

| 109 | laser light source |
|-----|--------------------|
| 113 | yawing correcting part |
| 114 | yawing correcting part |
| a | loader/unloader |
| b | alignment measurement |
| c | exposure |

[Fig.3]

| 121 | XY servo driver |
|-----|-----------------|
| 122 | coordinate converting part |
| 123 | first X axis driver |
| 124 | second X axis driver |
| 125 | Y axis driver |

[Fig.4]

| 123 | first X axis driver |
| 123a | X position speed controlling part |
| 123b | X1 current controlling part |
| 124 | second X axis driver |
| 124a | $\theta$ position speed controlling part |
| 124b | X2 current controlling part |
| 125 | Y axis driver |
| 125a | Y position speed controlling part |
| 125b | Y current controlling part |
| 122 | coordinate converting part |
| 101 | slider part |
| 126 | position detecting part |
| 127 | X1 motor |
| 128 | X2 motor |
| 129 | Y1 motor |
| 130 | Y2 motor |
| a | X1 axis laser light |
| b | X2 axis laser light |
| c | $\theta$ axis |
| d | Y axis laser light |

[Fig.5]

| 121 | XY servo driver |
| 122 | coordinate converting part |
| 123 | first X axis driver |

| 124 | second X axis driver |
| 125 | Y axis driver |

[Fig.6]

R: rolling

P: pitching

[Fig.7]

(A)

| 301 | Z1 sensor |
| 302 | Z2 sensor |
| 303 | Z3 sensor |
| 304 | Z4 sensor |
| 305 | Z1 coil |
| 306 | Z2 coil |
| 307 | Z3 coil |
| 308 | Z4 coil |

(B)

| 301 | Z1 sensor |
| 302 | Z2 sensor |
| 305 | Z1 coil |
| 306 | Z2 coil |
| a | air floating |
| b | suction force |

[Fig.8]

| | |
|---|---|
| 301 | Z1 sensor |
| 302 | Z2 sensor |
| 303 | Z3 sensor |
| 304 | Z4 sensor |
| 314 | 1/L calculating part |
| 318 | 1/4 calculating part |
| 316 | 1/L calculating part |
| 320 | pitching angle instructing part |
| 326 | position instructing part |
| 323 | rolling angle instructing part |
| 321 | error amplifier |
| 327 | error amplifier |
| 324 | error amplifier |
| 309 | current amplifier |
| 310 | current amplifier |
| 311 | current amplifier |
| 312 | current amplifier |
| 305 | Z1 coil |
| 306 | Z2 coil |
| 307 | Z3 coil |
| 308 | Z4 coil |

[Fig.9]

(A)

| 127 | X1 motor |
|-----|----------|
| 128 | X2 motor |
| 129 | Y1 motor |
| 130 | Y2 motor |
| 401 | Z11 sensor |
| 402 | Z12 sensor |
| 403 | Z21 sensor |
| 404 | Z22 sensor |

(B)

| 401 | Z11 sensor |
|-----|------------|
| 402 | Z12 sensor |
| a | air floating |
| b | suction force |

[Fig.10]

| a | mechanical angle 0° |
|---|---------------------|
| b | orthogonal current |
| c | mechanical angle 90° |
| d | control current |

[Fig.13]

| a | Y direction movement |
|---|----------------------|
| b | rolling |
| c | pitching |

[Fig. 14]

| a | Y direction movement |
|---|---|
| b | rolling |
| c | pitching |

[Fig. 15]

| 401 | Z11 sensor |
|---|---|
| 402 | Z12 sensor |
| 403 | Z21 sensor |
| 404 | Z22 sensor |
| 405 | X1 driver |
| 406 | X2 driver |
| 407 | Y1 driver |
| 408 | Y2 driver |
| 424 | 1/L calculating part |
| 418 | 1/L calculating part |
| 426 | 1/L calculating part |
| 420 | pitching angle instructing part |
| 426 | position instructing part |
| 423 | rolling angle instructing part |
| 421 | error amplifier |
| 427 | error amplifier |
| 424 | error amplifier |
| 409 | X1 orthogonal current generating part |
| 410 | X2 orthogonal current generating part |

| 411 | Y1 orthogonal current generating part |
| --- | --- |
| 412 | Y2 orthogonal current generating part |
| a | X moving direction |
| b | X pitching |
| c | X rolling |

[Fig.16]

| 126 | position detecting part |
| --- | --- |
| 501 | speed converter |
| 501 | position controlling part |
| 503 | speed controlling part |
| 504 | thrust generating part |
| 506 | acceleration sensor |
| 507 | thrust converting part |
| 600 | ripple restraining part |
| 601 | commutation phase detecting part |
| 602 | primary sine wave generating part |
| 603 | secondary sine wave generating part |
| 604 | constant number setting part |
| 605 | constant number correcting part |
| 606 | constant number correcting part |
| 607 | constant number generating parameter correcting part |
| a | (table) |
| b | constant number |
| c | (primary) |

d          (secondary)


[Fig.17]

A:          X axis control system

B:          Y axis control system

C:          θ axis control system

126         position detecting part

501A        speed converter

502A        position controlling part

503A        speed controlling part

504A        thrust generating part

700         ripple restraining means

701         commutation phase detecting part

702         x → x correction value generator

703         y → x correction value generator

704         correction constant number holding part

705         correction constant number holding part

501B        speed converter

502B        position controlling part

503B        speed controlling part

504B        thrust generating part

800         ripple restraining

801         commutation phase detecting part

802         y → y correction value generator

803         x → y correction value generator

| | |
|---|---|
| 804 | correction constant number holding part |
| 805 | correction constant number holding part |
| 501C | speed converter |
| 502C | position controlling part |
| 503C | speed controlling part |
| 504C | torque generating part |
| 900 | ripple restraining |
| 901 | x → θx correction value generator |
| 902 | y → θy correction value generator |
| 903 | correction constant number holding part |
| 904 | correction constant number holding part |
| a | X position |
| b | Y position |
| c | θ position |

[Fig.18]

| | |
|---|---|
| 126 | position detecting part |
| 127 | X1 motor |
| 501 | speed converter |
| 502 | position controlling part |
| 503 | speed controlling part |
| 504 | thrust generating part |
| 506 | acceleration sensor |
| 508 | acceleration controlling part |
| a | position instruction value |

[Fig.19]

| | |
|---|---|
| 501 | speed converter |
| 502 | position controlling part |
| 503 | speed controlling part |
| 509 | accumulation counter |
| 510 | higher apparatus |
| 511 | period detecting part |
| 512 | position converter |
| 513 | phase difference detecting part |
| 514 | commutation controlling part |
| 519 | current detecting part |
| 520 | current detecting part |
| 521 | current controlling part |
| 522 | dead time generating circuit |
| 1000 | dead time correction |
| 1001 | orthogonal current detecting part |
| a | U phase |
| b | V phase |
| c | W phase |

[Fig.20]

| | |
|---|---|
| 1 | lattice platen |
| 2 | slider part |
| 3 | slider part |

| 4 | device |
| 5 | device |
| 6 | controlling part |
| 7 | camera |
| 8 | inspecting part |

[Fig.21]

| 40 | XY driver |
| 41 | X axis driver |
| 42 | Y axis driver |

| **INTERNATIONAL SEARCH REPORT** | International application No. |
|---|---|
| | PCT/JP2006/302743 |

A. CLASSIFICATION OF SUBJECT MATTER
*G05D3/12*(2006.01), *G03F9/00*(2006.01), *G12B5/00*(2006.01), *H01L21/027*
(2006.01), *H01L21/68*(2006.01)

According to International Patent Classification (IPC) or to both national classification and IPC

B. FIELDS SEARCHED

Minimum documentation searched (classification system followed by classification symbols)
*G05D3/12*(2006.01), *G03F9/00*(2006.01), *G12B5/00*(2006.01), *H01L21/027*
(2006.01), *H01L21/68*(2006.01)

Documentation searched other than minimum documentation to the extent that such documents are included in the fields searched
Jitsuyo Shinan Koho        1922-1996   Jitsuyo Shinan Toroku Koho   1996-2006
Kokai Jitsuyo Shinan Koho  1971-2006   Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2005-25695 A  (Yokogawa Electric Corp.),<br>27 January, 2005 (27.01.05),<br>Full text; all drawings<br>(Family: none) | 1-4 |
| Y | JP 2000-65970 A  (Yokogawa Electric Corp.),<br>03 March, 2000 (03.03.00),<br>Full text; all drawings<br>(Family: none) | 1-4 |
| Y | JP 2002-116239 A  (Yokogawa Electric Corp.),<br>19 April, 2002 (19.04.02),<br>Full text; all drawings<br>(Family: none) | 1-4 |

☒ Further documents are listed in the continuation of Box C.        ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 09 May, 2006 (09.05.06) | 16 May, 2006 (16.05.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.

PCT/JP2006/302743

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2001-350525 A  (Yaskawa Electric Corp.),<br>21 December, 2001 (21.12.01),<br>Fig. 5<br>& US 2003/0169010 A1     & EP 1291747 A1<br>& EP 1496412 A1          & WO 2001/088649 A1<br>& CN 1429355 A           & TW 502141 B | 9<br>10 |
| Y | JP 2004-146807 A  (Canon Inc.),<br>20 May, 2004 (20.05.04),<br>Par. No. [0031]<br>& US 2004/0112164 A1 | 13 |
| A | JP 2004-120861 A  (Yokogawa Electric Corp.),<br>15 April, 2004 (15.04.04),<br>Par. No. [0053]<br>(Family: none) | 5-8 |
| A | JP 2003-250295 A  (Yokogawa Electric Corp.),<br>05 September, 2003 (05.09.03),<br>Par. No. [0033]<br>(Family: none) | 5-8 |
| A | JP 9-121558 A  (Nissan Motor Co., Ltd.),<br>06 May, 1997 (06.05.97),<br>Full text; all drawings<br>(Family: none) | 11-12 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002116239 A

- JP 2000065970 A